(19) Europäisches Patentamt
European Patent Office
Office européen des brevets

(11) EP 1 480 402 B1

(12) **EUROPEAN PATENT SPECIFICATION**

(45) Date of publication and mention of the grant of the patent:
**29.11.2006 Bulletin 2006/48**

(51) Int Cl.:
***H04L 27/36*** *(2006.01)* ***H03G 3/20*** *(2006.01)*
***H04B 7/005*** *(2006.01)*

(21) Application number: **03011716.2**

(22) Date of filing: **23.05.2003**

(54) **Automatic power control circuitry for a QAM transmitter unit of a wireless communication device**

Automatische Leistungregelungschaltung für eine QAM-Sendeeinrichtung in einem drahtlosen Kommunikationsgerät

Circuit de commande de puissance automatique pour une unité d'émission MAQ dans un dispositif de communication sans fils

(84) Designated Contracting States:
**AT BE BG CH CY CZ DE DK EE ES FI FR GB GR HU IE IT LI LU MC NL PT RO SE SI SK TR**

(43) Date of publication of application:
**24.11.2004 Bulletin 2004/48**

(73) Proprietor: **Sony Ericsson Mobile Communications AB**
**221 88 Lund (SE)**

(72) Inventors:
- **Radin-Macukat, Marjan,**
  **Sony Ericsson Mobile**
  **85609 Ascheim-Dornach (DE)**
- **Maletz, Thomas,**
  **Sony Ericsson Mobile**
  **85609 Ascheim-Dornach (DE)**

(74) Representative: **Rupp, Christian et al**
**Mitscherlich & Partner**
**Patent- und Rechtsanwälte**
**Sonnenstrasse 33**
**80331 München (DE)**

(56) References cited:
**EP-A- 0 961 402** **WO-A-94/10765**
**GB-A- 2 309 342**

- **STAPLETON S P ET AL: "A new technique for adaptation of linearizing predistorters" , 1991 IEEE 41TH. VEHICULAR TECHNOLOGY CONFERENCE. ST. LOUIS, MAY 19 - 22, 1991, IEEE VEHICULAR TECHNOLOGY CONFERENCE, NEW YORK, IEEE, US, VOL. CONF. 41, PAGE(S) 753-758 XP010037177 ISBN: 0-87942-582-2 * abstract * * Introduction * * figures 1,2 ***
- **DE MINGO J ET AL: "Amplifier linearization using a new digital predistorter for digital mobile radio systems" , VEHICULAR TECHNOLOGY CONFERENCE, 1997, IEEE 47TH PHOENIX, AZ, USA 4-7 MAY 1997, NEW YORK, NY, USA,IEEE, US, PAGE(S) 671-675 XP010228927 ISBN: 0-7803-3659-3 * I. Introduction * * II. Process * * figure 1 ***
- **BRIFFA M A ET AL: "DYNAMICALLY BIASED CARTESIAN FEEDBACK LINEARIZATION" , PERSONAL COMMUNICATION - FREEDOM THROUGH WIRELESS TECHNOLOGY. SECAUCUS, NJ., MAY 18 - 20, 1993, PROCEEDINGS OF THE VEHICULAR TECHNOLOGY CONFERENCE, NEW YORK, IEEE, US, VOL. CONF. 43, PAGE(S) 672-675 XP000393272 ISBN: 0-7803-1267-8 * abstract; figure 1 ***

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

### FIELD AND BACKGROUND OF THE INVENTION

The present invention generally relates to the field of coherent modulators which are deployed in wireless communication devices, in particular to three different types of a power control circuitry and a method for controlling the output power of a modulated RF signal to be transmitted at the output port of a power amplifier integrated in the QAM transmitter of a wireless communication device.

In the last few years the demand for high-efficient power control circuitries applied to wireless communication devices has ever increased. One key task in closed-loop power control is the design of analog circuitries to be integrated in the analog front end of a wireless RF transmitter which are used for controlling the output power $P_{out}$ of an RF signal $x(t)$ to be transmitted over the time $t$. Ramping too fast results in an unwanted spread of the RF spectrum, and a too slow ramping violates prescribed time constraints. The output power $P_{out}$, which is usually supplied by a power amplifier (PA) at the output port of the wireless RF transmitter, is thereby set by an external control voltage $V_{ctrl}$. The relation between $V_{ctrl}$ and $P_{out}$ is often nonlinear and influenced by temperature, tolerances, supply voltage, frequency and PA input power. To accomplish a sufficient stabilization of $P_{out}$, a power control loop is needed, although some designers still use non-feedback concepts, e.g. by controlling the PA supply voltage. Such a control loop typically comprises an RF detector and a loop amplifier which is supplied by an input signal from a baseband controller. Conventional power control loop designs mainly differ in the respectively applied RF detector, but the loop amplifier also involves interesting design aspects.

One important issue in power control loop design is the dynamic range. For a GSM-based mobile phone the maximum antenna power is 33 dBm, and the minimum power level is 5 dBm. The detector dynamic must be significantly higher, e.g. greater than 34 dB, which is relatively close to what a good diode detector is capable of. Another reason for the need of a large dynamic range is that e.g. in a conventional TDMA-based communication system the power amplifier starts from "power-down" mode in which the RF level is determined by noise and cross talk. This level should be lower than about -48 dBm for the GSM system, which would result in a dynamic range of more than 70 dB. If a control $V_{ctrl}$ voltage is applied to the control input of the power amplifier, the output power $P_{out}$ increases. But due to the finite detector dynamic, the loop is not locked and at the point the detector responds a large overshoot may occur.

Two issues make power control loop design a difficult task. One is that some power amplifiers are not very fast, which means that there might be a significant delay between a step $\Delta V_{ctrl}$ at the control input and the corresponding change $\Delta P_{out}$ in output power. This limits the speed of the power control loop and can cause instabilities. The second problem is that power amplifiers and many detectors are nonlinear circuit elements. When a power control loop is built with an ideal linear detector and a linear loop amplifier, an ideal power amplifier would have a constant slope $dP_{out}/dV_{ctrl}$, but in reality $dP_{out}/dV_{ctrl}$ is a function of the control voltage $V_{ctrl}$, which results in a bias-dependent overall loop gain and makes frequency compensation of the feedback system rather difficult. If the loop is stable, however, the circuit might be too slow for some power levels.

In Figs. 1a+b, a conventional wireless communication system consisting of a QAM transmitter 100a and a QAM receiver 100b is shown. On the transmitter side 100a of the system, the basic operations are as follows: The digital data is first encoded ($i_k$, $q_k$), and then, after being submitted to a digital-to-analog converter 102, the complex-valued orthogonal in-phase (I) and quadrature (Q) channels are combined by means of a quadrature modulator 104. The resulting signal combination is up-converted to an RF band by means of an internal mixing stage. Then, after having passed a filtering stage, the RF signal drives a power amplifier 106, whose output signal $x(t)$ is fed to a transmission (TX) antenna 108. The antenna radiates the signal into the air, and the transmission is complete. The receiver side 100b is simply the inverse, although slightly different components have to be used. First, the received RF signal $x(t)$ is filtered to select the RF band of interest. After that, it is fed to a low-noise amplifier 112 (LNA). Usually, the signal is then filtered and either directly down-converted from the RF band to the baseband (in case of a homodyne receiver) or mixed to one or more intermediate frequency (IF) stages (in case a heterodyne or superheterodyne receiver is employed). Thereby, the final mixing stage separates the signal into its I and Q components. Once at baseband, the I and Q signals are submitted to an analog-to-digital (A/D) converter 120 before being further processed.

The power amplifier is the component of the QAM transmitter 100a that amplifies the RF signal $x(t)$ to be transmitted to the necessary power level $P_{out}$ needed to drive the transmit antenna 108. In most wireless communications systems, the power amplifier is the largest power consumer, usually because the amount of power that needs to be sent to the antenna (the power output) is itself very large. This does not include the total power that is consumed within the power amplifier, just the amount of power which is required to drive the antenna. The total power consumed by the power amplifier is necessarily greater than the power output, as there will always be some power consumed in the active devices and the peripheral circuitry. Since the power output specification itself is often larger than the power consumption of the rest of the blocks in the RF system and the power consumption of such a power amplifier will be higher than the specified power output, the power amplifier is decidedly the major power consumer of the system.

Because the levels of power required to reliably transmit the modulated RF signal *x*(*t*) are often relatively high, there is a lot of power consumed within the power amplifier. In many wireless applications, the amount of power consumed by this amplifier is not critical; as long as the signal being transmitted is of adequate power, that is good enough. However, in a situation where there is only a limited amount of energy available, which is not sufficient for the transmission procedure, the power consumed by all devices must be minimized, so as to maximize the length of time for which that energy is available.

The number of different classes of power amplifiers which are used today is too numerous to be counted, and they range from entirely linear to entirely non-linear, as well as from quite simple to inordinately complex. In PA terminology, a "linear" power amplifier is one which has a linear relationship between its input and output. Although a power amplifier may comprise transistors operating in a nonlinear fashion (e.g. in case a FET switches between cut-off and saturation), it can still be considered linear. While nonlinear power amplifiers feature a comparatively high efficiency, their nonlinearity causes the output signal to spread (due to intermodulation products, especially if there is a lot of phase noise in the local oscillator which will cause spreading of the input to the power amplifier).

A typical power amplifier consists of several serial stages. Each stage is usually larger and more powerful than the previous one. As most of the quiescent current is drawn by the high power stages, which are not required for the low output power levels needed for wireless communication, means for bypassing high power stages when they are not required lead to a significant reduction of energy consumption.

Since wireless telephones operate on battery power, it is also desirable that their transmitters operate as efficiently as possible to conserve power and extend battery life. Ideally for W-CDMA systems, such as those governed by the UMTS standard, power amplifier stages should be capable of efficient, linear operation in their required dynamic range. However, the prior art has not yet come close to the ideal, and many wireless telephones are having poor power management now. During low power transmissions, power is wasted by cascaded amplifier stages that are not needed. Consequently, attempts have been made to bypass unused stages.

Under normal operating conditions, conventional wireless RF transceivers devices use an automatic power control (APC) circuit to control the output power of their amplification stages. The APC circuit found in most RF transceivers has an external connection that is intended to be connected to a linear power amplifier. After having detected the power of the modulated RF signal at the output port of the final power amplifier, said signal is converted to a DC voltage and fed back to a variable-gain intermediate frequency (IF) stage in order to keep the final output power constant over a long period of time. As the APC voltage generation is done very early, the gain drift, which is caused by thermal drift, operating voltage deviation, etc., is not compensated by the circuit. Another option is to derive the APC voltage from the drive power of the final amplifier and feed it to the external APC input of the RF transceiver. The theory is that when the power amplifier becomes overdriven, it will produce a negative voltage that is fed back into the transceiver's APC circuitry. This voltage acts as a gain control in the transmit stages of the transceiver which, in turn, automatically lowers the drive power (the transceiver's output power) and limits distortion from the overdriven amplifier.

Fig. 2a shows a schematic block diagram of a conventional APC loop 200a according to the state of the art, which is used for stabilizing the power at the RF output port 214b' of an analog circuitry realizing an RF signal generator. This circuit can also be used for executing an amplitude modulation. It comprises a frequency synthesizing unit 202' (FSU), a power divider 206' (e.g. a directional coupler), which feeds the reflected wave of the modulated RF output signal to a wideband detector diode 208', and an amplification stage 212' whose output signal is fed to an electronically controlled attenuator 204', e.g. an amplitude modulator stage which comprises current-controlled PIN diodes realizing a tunable resistor with hybrid microwave integrated circuit (MIC) technology. In case said RF signal generator is used for sweep-frequency applications, an external detector 208" (not shown) is usually applied in order to keep the power level at the input port of a tested RF unit constant.

Fig. 2 shows a schematic block diagram of a QAM transmitter 200 for a wireless communication device in an EDGE-based communication environment comprising an APC loop 201 according to the state of the art, which is used for stabilizing the power level $P_{out}$ at the RF output port 210 of the QAM transmitter 200. Thereby, the output port of a comparator stage 212, supplied with a reference signal $V_{ref}$ representing the nominal power level $P_{ref}$ for the desired output power level $P_{out}$ and the actual output power level $P_{out}$ fed back to the APC loop 201 by a wideband detector diode 208, is connected with the gain control input port of a variable-gain power amplifier 205, which controls the output power level $P_{out}$ of the QAM transmitter 200.

The complex-valued analog baseband signal $x_{LP}(t)$ (the complex envelope or equivalent low-pass signal of the real-valued RF band-pass signal *x*(*t*) to be transmitted) can thereby be written as follows:

$$x_{LP}(t) = i(t) + j \cdot q(t) = a(t) \cdot e^{j \cdot \varphi(t)} \quad (1)$$

with

$$i(t) := Re\left\{x_{LP}(t)\right\}, \qquad (1a)$$

$$q(t) := \mathrm{Im}\left\{x_{LP}(t)\right\}, \qquad (1b)$$

$$a(t) := \left|x_{LP}(t)\right| = \sqrt{i^2(t) + q^2(t)}, \qquad (1c)$$

$$\varphi(t) := \angle x_{LP}(t) = arc\ tan\left(\frac{q(t)}{i(t)}\right), \qquad (1d)$$

and $j := \sqrt{-1}$ is the imaginary unit. Thereby,

- $i(t)$ denotes the in-phase (I) component of $x_{LP}(t)$ in time domain,
- $q(t)$ denotes the quadrature (Q) signal of $x_{LP}(t)$ in time domain,
- $a(t)$ denotes the magnitude component of $x_{LP}(t)$, which is given by the envelope of $x(t)$, and
- $\phi(t)$ denotes the phase component of $x_{LP}(t)$, which is also the phase component of $x(t)$.

$i(t)$ and $q(t)$ are directly up-converted from the baseband to an RF band by means of two modulator stages 204a and 204b, respectively, which are driven by a local oscillator 202 providing a high-frequent carrier signal with a sinusoidal waveform

$$c_i(t) \equiv c(t) := A_c \cdot cos\left(2\pi \cdot f_{LO} \cdot t\right), \qquad (2a)$$

wherein $A_C$ (in $\sqrt{\mathrm{W}}$ ) is the amplitude factor of the carrier signal $c_i(t)$ and $f_{LO}$ (in GHz) is the carrier frequency supplied by the local oscillator 202. A Hilbert transformer 204c, connected to one input port of the up-conversion mixer 204a, provides a 90-degree phase shift of the carrier signal $c_i(t)$ such that the carrier signal used for a direct up-conversion of the quadrature signal $q(t)$ from the baseband to the RF band is given by

$$c_q(t) := A_c \cdot cos\left(2\pi \cdot f_{LO} \cdot t + \frac{\pi}{2}\right) = -A_c \cdot sin\left(2\pi \cdot f_{LO} \cdot t\right). \qquad (2b)$$

Using $x_{LP}(t)$ (or $i(t)$ and $q(t)$, respectively), the modulated RF signal $x(t)$ to be transmitted can thus be written as follows:

$$\begin{aligned} x(t) &= Re\left\{x_{LP}(t) \cdot e^{+j \cdot 2\pi \cdot f_{LO} \cdot t}\right\} = i(t) \cdot c_i(t) + q(t) \cdot c_q(t) \\ &= i(t) \cdot cos\left(2\pi \cdot f_{LO} \cdot t\right) - q(t) \cdot sin\left(2\pi \cdot f_{LO} \cdot t\right) \qquad (3) \end{aligned}$$

Before being transmitted, the obtained RF signal $x(t)$ has to be amplified since a certain output power level $P_{out}$ is needed to reach a receiver at a certain distance. For this reason, a gain-controlled power amplifier 205 is needed.

As the invention refers to an EDGE-based QAM transmitter of a wireless communication device in a communication network based on time-division multiplexing (TDM), wherein each QAM channel in upstream direction is subdivided into a predefined number of time-division multiple access (TDMA) channels, eight physical TDMA channels using the same carrier frequency $f_{LO}$ have to be realized. Fig. 3a shows the typical structure of a TDMA frame 300a with eight time slots, each having a slot length $T_s$ of 156.25 bit and a burst length $T_{Burst}$ of 148 bit as used in a conventional TDMA-based communication system. As eight different mobile terminals can be mapped onto these eight time slots, every mobile terminal has one (several in GPRS) TDMA channel for transmitting or receiving, respectively; on the other TDMA channels the mobile terminal is not allowed to send since the corresponding time slots are allocated to other mobile terminals.

Due to the bursted nature of the RF power of a transmitted signal stream in the uplink of a TDMA-based communication system, the output power of a wireless RF transmitter has to be ramped up to an appropriate level or ramped down to zero between different time slots, respectively, such that the RF output power is constant during transmission in order to facilitate time-division multiplexing of different TDMA channels. A typical burst profile 300b of the RF output power $P_{out}$ of a transmitted signal stream in the uplink of a TDMA-based communication system over the time $t$ is depicted in Fig. 3b. It can be seen that the output power $P_{out}$ of a wireless RF transmitter 200b has to be ramped up to an appropriate level or ramped down to zero between adjacent time slots $TS_i$ and $TS_j$ for $j := (i+1)$ *mod* 8 and $i \in \{0, 1, 2, ..., 7\}$ such that the output power level $P_{out}$ is constant during transmission in order to facilitate time-division multiplexing between different TDMA channels. A certain time before the transmission of the data starts, the mobile terminal increases the transmission power from zero to the desired output power $P_{out}$. This part of the respective time slot $TS_i$ is called "ramp up". After the desired output power $P_{out}$ is reached, the transmission of the data starts. This part of the respective time slot $TS_i$ is normally referred to as "useful part". The last part of $TS_i$ is then called "ramp down".

Today, this ramp-up and ramp-down procedure for stabilizing the output power level $P_{out}$ of a QAM transmitter 200 is realized by means of an APC circuitry 201 according to the state of the art as depicted in Fig. 2. Thereby, the output port of a comparator stage 212 supplied with a reference signal $V_{ref}$ representing the nominal power level $P_{ref}$ for the power $P_{out}$ of the RF output signal and the actual output power level $P_{out}$ is connected to the gain control input port of a variable-gain power amplifier 205 controlling said output power level $P_{out}$. The actual output power level $P_{out}$ is supplied either by direct measurement (as shown in Fig. 2, where a part of $P_{out}$ is coupled out by means of a directional coupler 206 and fed back to the APC loop 201 by means of a wideband detector diode 208) or by indirect measurement (e.g. by measuring the output current of the power amplifier 205, which is direct proportional to the output power $P_{out}$). The measured power level $P_{out}$ is then compared with the nominal power level $P_{ref}$ If the actual power level $P_{out}$ is higher than the power level $P_{ref}$ of the reference signal, the gain $G_{PA}$ of the variable-gain power amplifier 205 is decreased in order to adjust $P_{out}$. Vice versa, $G_{PA}$ is increased if $P_{out}$ is lower than $P_{ref}$ to adjust $P_{out}$. During the "ramp-up" part the nominal power level $P_{ref}$ is increased, during the "ramp-down" part it is decreased, and during the "useful" part it remains stable. Since the APC loop 201E adjusts the output power level $P_{out}$ according to the power level $P_{ref}$ of the reference signal, the output power $P_{out}$ is ramped up or down, respectively, and remains at a predefined level during the "useful" part.

## BRIEF DESCRIPTION OF THE STATE OF THE ART

GB 2 309 342 A discloses a method for reducing adjacent channel interference which is generated by a wireless communication unit operating in a TDMA-based communication system, wherein said communication unit comprises a Cartesian feedback linear direct-conversion transmitter circuit for transmitting time-division-multiplexed digital signals based on a time-slotted communication protocol. The herein proposed method includes the steps of transmitting information during allocated time slots and successively switching different attenuator elements of an adjustable attenuator array to the transmitter circuit during the ramp-up or ramp-down period of a particular time slot in order to reduce adjacent channel interference. A frequency up-conversion circuit that is realized as a quadrature modulator stage comprising an up-conversion mixer and a first attenuator array consisting of a set of adjustable attenuator elements for providing an RF output signal to a power amplifier as well as a frequency down-conversion circuit which is realized as a quadrature demodulator stage comprising a down-conversion mixer and a second attenuator array consisting of a further set of adjustable attenuator elements for providing a baseband feedback signal corresponding to an RF feedback signal supplied by a directional coupler at the RF output port of the linear transmitter, said RF feedback signal being representative of said RF output signal, are provided. During operation of the Cartesian feedback linear direct-conversion transmitter, a digital baseband input signal fed to a baseband linearization circuit of this linear transmitter is converted into the in-phase ($I$) and quadrature ($Q$) components of an analog complex-valued quadrature baseband input signal. The frequency up-conversion circuit receives a low-pass-filtered version of the complex-valued quadrature baseband input signal and an attenuated version of an at least approximately sinusoidal carrier signal serving as a frequency up-conversion signal which is supplied from a local oscillator and provides the corresponding RF output signal to be transmitted. Said frequency up-conversion circuit thereby comprises the first attenuator array whose attenuator elements are used for adjusting a power level of the frequency up-conversion signal. The obtained RF output signal is then fed to a power amplifier. A directional coupler which is post-connected to the power amplifier couples out a portion of the RF signal at the output port of the power amplifier, thus providing the RF feedback signal as mentioned above. A frequency down-conversion signal given by a further attenuated version of the sinusoidal carrier generated by said local oscillator is then fed to the second attenuator array whose attenuator elements are used for adjusting a power level of the frequency down-conversion signal and mixed with the RF feedback signal fed to the down-conversion mixer of the frequency down-conversion circuit, thus providing the baseband feedback signal, which is then added to the in-phase and quadrature components of the analog complex-valued quadrature baseband input signal to be transmitted. To summarize, in the Cartesian feedback linear direct-conversion transmitter circuit as described in this prior-art document power control for the RF output signal to be transmitted is achieved by selecting the attenuation factors of the adjustable attenuator elements comprised in the first and second attenuator array concurrently so as to linearize the power amplifier's amplitude and phase response and compensate amplitude and/or phase instabilities of the analog complex-valued quadrature baseband input signal by adding a down-converted and amplified version of the RF feedback signal representing the RF output signal to be transmitted to the in-phase component and to the quadrature component of the analog complex-valued quadrature baseband input signal, respectively. According to the invention disclosed in GB 2 309 342 A, said power control is performed by varying the attenuation level of an up-conversion forward attenuator module implementing the adjustable attenuator elements of the first attenuator array from a minimum value ($a_0$ = 0 dB) to a maximum value ($a_N = a_0 + N \cdot \Delta a$ = 20 dB) by $N$ = 4 attenuation increments of $\Delta a$ = 5 dB during the ramp-up period and, vice versa, varying the attenuation level of a down-conversion feedback attenuator module implementing the adjustable attenuator elements of the second attenuator array from said maximum value ($a_N$ = 20 dB) to said minimum value ($a_0$ = 0 dB) by $N$ = 4 attenuation decrements of $\Delta a$ = 5 dB during the ramp-down period.

The invention described in EP 0 961 402 A2 refers to a transmitter and a method for gain control in a QAM transmitter of a mobile terminal in a spread-spectrum multiple access system based on CDMA which makes efficient use of battery power and avoids glitches in the power level of the RF signal to be transmitted by providing different paths with different gains for said RF signal.

Next, the invention described in US 2002/0123363 A1 pertains to a method and a device for compensating a data-dependency of a power measurement caused by linear modulation. The method comprises the steps of performing a first measurement of a transmitted output power and performing a second measurement of a reflected power, wherein both measurements are performed in a time-multiplex fashion. The method further comprises the steps of calculating a first average power based on data transmitted during the first measurement, calculating a second average power based on data transmitted during the second measurement, and compensating at least one of the measured power values based on the difference between the first average power and the second average power.

US 5,276,917 discloses a method for executing a transmitter power switch-on in a dual-mode transmitter of a mobile radiotelephone which comprises an APC loop and means for controlling the switching-on of at least two transmitting power amplifier stages coupled in series to a duplex circuit, which are needed to ensure a stable operation of the transmitter. In front of the power amplifier stages, a voltage-controlled amplifier and attenuator (VCA) is placed, which receives a feedback signal from a power control block in the feedback chain of the APC loop. The method comprises the step of sequentially switching on said power amplifier stages. After that, a transmit power control signal (TXC) is switched on. According to another embodiment of this invention, first the output power amplifier stages are switched on, enabled by a transmit enable signal (TXE). Thereafter, the input power amplifier stages are switched on, enabled by a ramp-up control signal (RAMP-UP), and finally a transmit power control signal (TXC) is switched on. The power amplifiers then output the amplified RF signal $x(t)$ to a transmit terminal of the duplex circuit.

The invention described in WO 03/001688 A2 is directed to a radio transmitter of a mobile communication device, in which the bandwidth of a smoothing filter needed for removing transient spurious signals caused by the switching of an integrated power amplifier is adjusted based on the power level $P_{out}$ of an RF signal $x(t)$ to be transmitted and/or on a mode of operation. The bandwidth of the filter is thereby adjusted by controlling a transconductance element in the filter. For this purpose, the filter characteristics can be controlled such that an acceptable switching spectrum is achieved, thereby allowing the output power $P_{out}$ of the power amplifier to ramp up acceptably quickly. For example, the filter parameters can be adjusted depending on the applied communications standard (e.g. GSM-850, GSM-900, DCS, or PCS) under which the device is operating and depending on the power level $P_{out}$ of the RF signal $x(t)$ to be transmitted.

Besides, the inventions disclosed in EP 0 944 175 A1 and US 6,212,367 B1 refer to a mobile phone apparatus which is capable of meeting stringent specifications on transmitter noise in the receive (Rx) band. The mobile phone apparatus thereby comprises a modulator for producing a modulated RF signal $x(t)$ to be transmitted in a transmit (Tx) band, a power amplifier for supplying said RF signal $x(t)$ to a transmit antenna, a tunable filter having a passband and an attenuation band, which is disposed between the modulator and the power amplifier, and a control circuit for tuning the filter such that the passband is at the Tx band and the attenuation band is at an Rx band of the mobile phone apparatus.

A transmitter output power control circuit for use in a radio telephone is disclosed in US 5,752,172. Said transmitter circuit thereby comprises a power amplifier having an output coupled to an antenna for transmitting an amplified modulated RF signal $x(t)$, a variable-gain driver amplifier (VGA) having an output port coupled to an input port of the power amplifier and an input port coupled to an output port of a modulator, which is required to output the modulated RF signal $x(t)$ within a predetermined dynamic power range, and at least one programmable-gain amplifier (PGA1, PGA2) coupled in series between the output port of the modulator and the input port of the VGA. The programmable-gain amplifier has a dynamic range selected for reducing the dynamic range requirement of the variable-gain driver amplifier to be less than said predetermined dynamic power range.

Finally, the invention disclosed in US 6,118,988 refers to a transmission power control system for use in a mobile phone and a corresponding method that control the magnitude of the transmission power $P_{out}$ of a modulated RF signal $x(t)$ to be transmitted in proportion to the distance between a base station (BS) and the mobile station (MS) of a user. The transmission power control system thereby provides the exact transmission power level $P_{out}$ by compensating for an error between a real gain and a gain-controlled value according to the magnitude of the transmission power $P_{out}$. According to one embodiment of this invention, the transmission power control system comprises a transmission part, a mobile station modem, a power detector, a gain difference controlling part, and a power amplifier controlling part. First, the transmission power signal supplied by the transmission part is transformed into a DC voltage by a power detector. The mobile station modem then outputs a first and a second gain control value, respectively, based on the DC voltage. After that, the gain difference controlling part generates a gain difference control signal and applies this gain difference control signal to the transmission part in accordance with said first gain control value and an attenuated signal. The power amplifier controlling part outputs a power amplifier gain control value to the transmission part in accordance with the obtained DC voltage representing the transmission power signal and the second gain control value.

## OBJECT OF THE UNDERLYING INVENTION

In view of the state of the art mentioned above, it is the object of the underlying invention to provide an automatic power control (APC) circuit for amplifying RF signals which reduces the problems with noise generation in multi-stage power amplifiers during the transitions between attenuation mode ("OFF stage") and amplification mode ("ON stage").

The aforementioned object is achieved by means of the features in the independent claims. Advantageous features are defined in the dependent claims.

## SUMMARY OF THE INVENTION

The present invention is basically dedicated to a QAM transmitter of a wireless communication device in a wireless cellular network environment based on time-division multiplexing (TDM), wherein each QAM channel in upstream direction is subdivided into a predefined number of time-division multiple access (TDMA) channels and each mobile terminal participating in communication is allocated to a periodically repeated time slot $TS_i$ of a predetermined length $T_{TS}$. This QAM transmitter comprises a modulator stage with two up-conversion mixers, driven by a local oscillator for directly up-converting the in-phase (I) and quadrature (Q) signal of a complex-valued analog baseband signal $x_{LP}(t)$ to be transmitted from the baseband to an RF band, a 90-degree phase shifter, connected to an LO input port of one of these up-conversion mixers in a quadratum chain of said modulator stage, and a summation element for combining the RF output signals of the two up-conversion mixers. Furthermore, said QAM transmitter comprises a variable-gain power amplifier post-connected to the summation element and an automatic power control loop for stabilizing the power level $P_{out}$ of the modulated RF signal $x(t)$ at the output port of the QAM transmitter. Said power control loop encompasses a comparator stage, supplied with a reference signal $V_{ref}$ representing a nominal power level $P_{ref}$ for a desired output power level $P_{out}$ of the RF signal $x(t)$ and with an RF feedback signal representing an actual output power level $P_{out}$ of said RF signal $x(t)$, supplied by a directional coupler and fed back to the automatic power control loop by a wideband detector diode. The output signal of the aforementioned comparator stage is fed to a control input port of a voltage-controlled attenuator placed in the modulator stage, which is used for attenuating the power level $P_c$ of the oscillator signal supplied by the local oscillator of the modulator stage.

## BRIEF DESCRIPTION OF THE DRAWINGS

Advantageous features, aspects, and useful embodiments of the invention will become evident from the following description, the appended claims, and the accompanying drawings. Thereby,

Fig. 1a depicts a schematic block diagram of a conventional QAM transmitter for a wireless communication device, which uses an I/Q modulator according to the state of the art,

Fig. 1b depicts a schematic block diagram of a conventional QAM receiver for a wireless communication device, which uses an I/Q demodulator according to the state of the art,

Fig. 2 shows a schematic block diagram of a QAM transmitter with an automatic power control (APC) circuitry according to the state of the art, which is used for stabilizing the power level at the output port of the QAM transmitter, wherein the output port of a comparator stage supplied with a reference signal representing the nominal power level for the power of the RF output signal and the actual output power level is connected to the gain control input port of a variable-gain power amplifier (PA) which controls the output power level,

Fig. 2a shows a schematic block diagram of an analog RF signal generator comprising a conventional APC loop for stabilizing the power level at the output port of the RF signal generator according to the state of the art, which is characterized in that the output signal of a comparator stage supplied with a reference signal representing the nominal power level for the desired output power level of the RF output signal and the actual output power level is fed to the control input port of an electronically controllable attenuator controlling the output power level,

Fig. 2b shows a schematic block diagram of a QAM transmitter comprising an APC loop for stabilizing the power level at the output port of an integrated power amplifier according to a first embodiment of the present invention, which is realized as a closed-loop circuitry and characterized in that the output signal of an integrated comparator stage supplied with a reference signal representing the nominal power level for the desired output power level of the RF output signal and with the actual output power level is fed to the control input port of a voltage-controllable attenuator (VCA) controlling the output power level,

Fig. 2c shows a schematic block diagram of a QAM transmitter comprising an APC loop for stabilizing the power level at the output port of the integrated power amplifier according to a second embodiment of the present invention, which is realized as an open-loop circuitry and characterized in that the control input port of said VCA is connected to a microcontroller (μC) providing an external control signal,

Fig. 2d shows a schematic block diagram of a QAM transmitter comprising an APC loop for stabilizing the power level at the output port of the power amplifier according to a third embodiment of the present invention, which is realized as a closed-loop circuitry and characterized in that the output signal of an integrated comparator stage supplied with a reference signal representing the nominal power level for the desired output power level of the RF output signal and with the DC supply current of the power amplifier is fed to the control input port of a VCA controlling the output power level,

Fig. 3a illustrates the typical structure of a TDMA frame with eight time slots used in a TDMA-based communication system,

Fig. 3b shows the obtained burst profile of the RF output power of a transmitted signal stream in the uplink of a TDMA-based communication system over the time, wherein the output power of a wireless RF transmitter has to be ramped up to an appropriate level or ramped down to zero between adjacent time slots such that the RF output power level is constant during transmission in order to facilitate time-division multiplexing of different RF transmitters, and

Fig. 4 shows a flow chart illustrating a method for stabilizing the power level of a modulated RF signal to be transmitted by the QAM transmitter of a wireless communication device according to the present invention.

DETAILED DESCRIPTION OF THE UNDERLYING INVENTION

In the following, one embodiment of the underlying invention as depicted in Fig. 2b shall be explained in detail. The meaning of the symbols designated with reference signs in Figs. 1a to 4 can be taken from an annexed table.

Fig. 2b illustrates a new approach for controlling the output power level $P_{out}$ according to one embodiment of the present invention. Thereby, the shaping of $P_{out}$ over time, i.e. the ramp-up and ramp-down procedure as well as the procedure for stabilizing $P_{out}$ during the time $T_{Burst}$ are executed by controlling the power level $P_c$ of the local oscillator 202, i.e. the amplitude $A_c$ of the carrier signal. The idea is to apply a voltage-controlled attenuator 203, whose attenuation factor $a$ (in dB) can continuously be adjusted (beginning from $a$ = 0 dB). Since the analog baseband signals $i(t)$ and $q(t)$ are up-converted to an RF band by means of sinusoidal carrier signals $c_i(t)$ and $c_q(t)$, the output power $P_{Mod}$ of the modulator stage 204E can be calculated as follows:

$$P_{Mod} = G_{Mod} \cdot k \cdot P_{i,q} \cdot P_c \quad (4a)$$

with

$$P_{i,q} := P_i + P_q , \quad (4b)$$

wherein $G_{Mod}$ is the gain factor of the modulator, $P_i$ and $P_q$ (in W) are the power levels of the in-phase signal $i(t)$ and the quadrature signal $q(t)$, respectively, $P_c$ (in W) is the power level of the carrier signals $c_i(t)$ and $c_q(t)$, $P_{Mod}$ (in W) is the power level of the modulator output signal, and $k$ (in $W^{-1}$) is a scaling factor, which is necessary to obtain $P_{out}$ with the right unit (in W). In the following, it shall be assumed that $k = 1\ W^{-1}$ and $G_{Mod}$ is a dimensionless variable that denotes the total modulator gain. The output power level $P_{out}$ of the QAM transmitter 200b can then be written as follows:

$$P_{out} = G_{PA} \cdot P_{Mod} = G \cdot k \cdot P_{i,q} \cdot P_c \quad (5a)$$

with

$$G := G_{PA} \cdot G_{Mod} , \quad (5b)$$

wherein $G_{PA}$ is the gain factor of the power amplifier 205. If a voltage-controlled attenuator 203 is added, equation (5a) yields

$$P_{out} = a \cdot G_{PA} \cdot P_{Mod} = a \cdot \underbrace{G \cdot k \cdot P_{i,q} \cdot P_c}_{=:\ P\ (\text{in W})} , \quad (6a)$$

wherein $a$ is the attenuation of the voltage-controlled attenuator 203. It can be seen that $P_{out}$ is only a function of $a$ if G, $k$, $P_{i,q}$ and $P_c$ are constant:

$$P_{out} \sim a \quad \text{for} \quad P := G_{PA} \cdot P_{Mod} = G \cdot k \cdot P_{i,q} \cdot P_c = const. \quad (6b)$$

For high values of G, $P_{i,q}$ and $P_c$, the stabilization of $P_{out}$ can be done by adjusting the attenuation factor a of the voltage-controlled attenuator 203.

A first embodiment of the present invention refers to a QAM transmitter 200b as depicted in Fig. 2b, wherein a reference signal representing the nominal power level $P_{ref}$ for the desired output power level $P_{out}$ of the RF output signal is fed to a first input port of the comparator stage 212 and a feedback signal (FS) which represents the actual power level $P_{out}$ of the RF signal $x(t)$ is fed to a second input port of the comparator stage 212.

In a first and second embodiment, said automatic power control circuitry 201E is realized as a closed-loop circuitry, wherein the control input port of said voltage-controlled attenuator 203 is connected to the output port of the comparator stage 212 and either the detected signal amplitude of the RF signal $x(t)$ to be transmitted or the supply current $I_{PA}$ of a power amplifier 205 is used as said feedback signal. In a third embodiment, said automatic power control circuitry 201E is realized as an open-loop circuitry, wherein the control input port of said voltage-controlled attenuator 203 is connected to a microcontroller (μC) providing an external control signal (PA Control).

A further aspect of the invention pertains to a method for stabilizing the power level $P_{out}$ of a modulated RF signal $x(t)$ to be transmitted by the QAM transmitter 200b of a wireless communication device during the burst period $T_{Burst}$ of the periodically repeated time slot $TS_i$ allocated to said wireless communication device. A flow chart 400 illustrating this method is depicted in Fig. 4. After having detected (S1) the actual power level $P_{out}$ of the RF output signal

$x(t)$, feeding back (S2) said actual power level $P_{out}$ to a first input port of a comparator stage 212 in the feedback chain of the automatic power control loop 201E and comparing (S3) said actual power level $P_{out}$ with a reference signal $V_{ref}$ representing the nominal power level $P_{ref}$ for the desired output power level $P_{out}$ of the RF output signal fed to a second input port of the comparator stage 212, the actual power level $P_{out}$ is adjusted (S0) by controlling the attenuation factor a of a voltage-controlled attenuator 203 in the modulator stage 204E of the QAM transmitter 200b, that is used for attenuating the power level $P_c$ of the approximately sinusoidal oscillator signal supplied by the local oscillator 202 of the modulator stage 204E. In case the absolute value of the difference between $P_{ref}$ and $P_{out}$ is less than or equal to a predefined threshold value $\Delta P_{thres}$, the algorithm terminates; otherwise, the procedure is continued with step S1. Thereby, the non-linear PA gain control (cf. Fig. 2) is replaced by a linear circuit element - the voltage-controlled attenuator 203 (VCA) -, thus avoiding problems with noise generation in multi-stage power amplifiers during the transitions between attenuation mode ("OFF stage") and amplification mode ("ON stage"). Furthermore, the gain factor $G_{PA}$ of the power amplifier 205 can be adjusted by means of an external PA control signal. For example, it can be turned to maximum during the burst period $T_{Burst}$ and turned off outside the burst period $T_{Burst}$ to improve adjacent channel isolation.

Instead of detecting (S1) the actual power level $P_{out}$ of the RF output signal $x(t)$, feeding back (S2) said actual power level $P_{out}$ to a first input port of a comparator stage 212 in the feedback chain of the automatic power control loop 201E, comparing (S3) $P_{out}$ with a reference signal $V_{ref}$ representing the nominal power level $P_{ref}$ for the desired output power level $P_{out}$ of the RF output signal fed to a second input port of the comparator stage 212 and compensating (S4) instabilities of the RF output power $P_{out}$ by controlling the attenuation factor *a* of a voltage-controlled attenuator 203 based on magnitude and sign of the difference between the actual power level $P_{out}$ and the nominal power level $P_{ref}$ according to a first approach of the present invention depicted in Fig. 2b, the following two approaches for stabilizing the power level *Pout* of a modulated RF signal $x(t)$ to be transmitted are also conceivable:

According to a second approach of the present invention depicted in Fig. 2c, instabilities of the RF output power $P_{out}$ are compensated (S2') by accessing (S1') information stored in an integrated memory of the wireless communication device concerning device-specific hardware tolerances, which are explicitly pointed out by the device manufacturer, and/or information concerning influences caused by temperature drifts $dT/dt$, battery voltage drifts $dU_{batt}/dt$, etc., which are measured during the development of the wireless communication device, without actually needing to measure $P_{out}$.

According to a third approach of the present invention, these instabilities are compensated (S4") by measuring (S1") the DC supply current $I_{PA}$, of the power amplifier 205, feeding (S2") a voltage $U_{RM}$ proportional to $I_{PA}$ to a first input port of the comparator stage 212 and comparing (S3") $U_{RM}$ with a reference signal $V_{ref}$ representing the nominal power level $P_{ref}$ for the desired output power level $P_{out}$ of the RF output signal fed to a second input port of the comparator stage 212. In contrast to the first approach, said output power level $P_{out}$ is not directly observed. How the measured current consumption of the power amplifier 205 is related to the RF output power level $P_{out}$ of the wireless communication device can be determined by accessing information stored in an integrated memory of said device. In this case, the detector is not an RF sensor 208 but a current sensor, realized as a low-ohm resistor $R_M$, which is placed in the power supply line of the power amplifier 205.

In all three approaches, the gain factor $G_{PA}$ of said power controller 205 can either be fix or controlled by an external PA control signal. In the first case, no logic is needed to decide when to switch on which gain stage. However, if the gain factor $G_{PA}$ remains at a maximum value, power is wasted in gain stages which are not used. In the latter case, a microcontroller can be used for switching a number of serially switched gain stages on or off.

Dependent on the respective gain factor $G_{PA}$ needed to obtain the desired value of the RF output power $P_{out}$, usually one, two or three gain stages can be activated. The microcontroller thereby turns on needed gain stages, and fine tuning of $P_{out}$ is achieved by realizing anyone of the above-described three approaches.

According to a still further aspect of the present invention, the gain factor $G_{PA}$ of the power amplifier 205 can be adjusted (S5) by means of an external power amplifier control signal (PA control). Thereby, said gain factor ($G_{PA}$) is set to its maximum value within the burst period $T_{Burst}$ and set to zero outside said burst period $T_{Burst}$ to improve adjacent channel isolation.

A further embodiment of the present invention relates to a wireless communication device in a communication network based on time-division multiplexing (TDM), wherein each QAM channel in upstream direction is subdivided into a predefined number of time-division multiple access (TDMA) channels and each mobile terminal participating in communication is allocated to a periodically repeated time slot ($TS_i$) of a predefined length ($T_{TS}$), wherein a QAM transmitter 200b as described above is applied.

**Table: Depicted Features and Their Corresponding Reference Signs**

| No. | System Component or Procedure Step |
|---|---|
| 100a | schematic block diagram of a conventional QAM transmitter for a wireless communication device, which uses an I/Q modulator according to the state of the art |
| 100b | schematic block diagram of a conventional QAM receiver for a wireless communication device, which uses an I/Q demodulator according to the state of the art |
| 102 | digital-to-analog (D/A) converter in the baseband part of the QAM transmitter 100a |
| 104 | I/Q modulator stage of the QAM transmitter 100a for directly up-converting a complex-valued analog baseband signal $x_{LP}(t) = i(t) + j \cdot q(t)$ (with $j := \sqrt{-1}$ being the imaginary unit) to be transmitted from the baseband to an RF band |
| 106 | power amplifier (PA) in the RF part of the QAM transmitter 100a |
| 108 | transmitting (TX) antenna of the QAM transmitter 100a |
| 110 | receiving (RX) antenna of the QAM receiver 100b |
| 112 | low-noise amplifier (LNA) in the RF part of the QAM receiver 100b |
| 114 | down-conversion mixer of the QAM receiver 100b for down-converting the received RF signal $x(t)$ from the passband to an intermediate frequency (IF) |
| 116 | channel-select filter of the QAM receiver 100b, realized as a band-pass filter (BPF), for attenuating spurious out-of-band components contained in the signal spectrum of the obtained IF signal at the output port of the channel-select filter 116 |
| 118 | I/Q demodulator stage of the QAM receiver 100b for down-converting the obtained IF signal at the output port of the channel-select filter 116 from the IF to the baseband |
| 120 | analog-to-digital (A/D) converter in the baseband part of the QAM receiver 100b |
| 122 | local oscillator (LO) of the QAM receiver 100b, which provides a sinusoidal oscillator signal with a tunable frequency |
| 200 | schematic block diagram of a QAM transmitter with an automatic power control (APC) circuitry 201 according to the state of the art, which is used for stabilizing the power level $P_{out}$ at the output port of the QAM transmitter 200, wherein the output port of a comparator stage 212 supplied with a reference signal $V_{ref}$ which represents the nominal power level $P_{ref}$ for the power $P_{out}$ of the RF output signal $x(t)$ and the actual output power level $P_{out}$, supplied by a directional coupler 206 and fed back to the APC loop 201 by a wideband detector diode 208, is connected to the gain control input port of a variable-gain power amplifier 205 controlling said output power level $P_{out}$ |
| 200a | schematic block diagram of an analog RF signal generator comprising a conventional automatic power control (APC) loop 201 S according to the state of the art, which is used for stabilizing the power level $P_{out}$ at the output port of the RF signal generator 200a, characterized in that the output signal of a comparator stage 212' supplied with a reference signal $V_{ref}$ representing the nominal power level $P_{ref}$ for the desired output power level $P_{out}$ of the RF output signal $x(t)$ and the actual output power level $P_{out}$, supplied by a directional coupler 206' and fed back to the APC loop 201S by a wideband detector diode 208', is fed to the control input port of an electronically controllable attenuator 203' controlling said output power level $P_{out}$ |

(continued)

| No. | System Component or Procedure Step |
|---|---|
| 200b | schematic block diagram of a QAM transmitter comprising an APC loop 201E for stabilizing the power level $P_{out}$ at the output port of an integrated power amplifier 205 according to a first embodiment of the present invention, that is realized as a closed-loop circuitry and characterized in that the output signal of an integrated comparator stage 212 supplied with a reference signal $V_{ref}$ representing the nominal power level $P_{ref}$ for the desired output power level $P_{out}$ of the RF output signal $x(t)$ and with the actual output power level $P_{out}$, supplied by a directional coupler 206 and fed back to the APC loop 201E by a wideband detector diode 208, is fed to the control input port of a voltage-controlled attenuator 203 (VCA) controlling the output power level $P_{out}$ |
| 200c | a schematic block diagram of a QAM transmitter comprising an APC loop for stabilizing the power level $P_{out}$ at the output port of the integrated power amplifier 205 according to a second embodiment of the present invention, which is realized as an open-loop circuitry and characterized in that the control input port of said VCA 203 is connected to a microcontroller (μC) providing an external control signal (PA Control) |
| 200d | schematic block diagram of a QAM transmitter comprising an APC loop 201E for stabilizing the power level $P_{out}$ at the output port of the power amplifier 205 according to a third embodiment of the present invention, which is realized as a closed-loop circuitry and characterized in that the output signal of an integrated comparator stage 212 supplied with a reference signal $V_{ref}$ representing the nominal power level $P_{ref}$ for the desired output power level $P_{out}$ of the RF output signal $x(t)$ and with the DC supply current $I_{PA}$ of the power amplifier 205 is fed to the control input port of a VCA 203 controlling the output power level $P_{out}$ |
| 201 | automatic power control (APC) loop of a QAM transmitter 200 according to the state of the art (cf. Fig. 2), which is used for stabilizing the power level $P_{out}$ at the output port of the QAM transmitter 200, characterized in that the output signal of a comparator stage 212 supplied with a reference signal $V_{ref}$ representing the nominal power level $P_{ref}$ for the desired output power level $P_{out}$ of the RF output signal $x(t)$ and the actual output power level $P_{out}$, supplied by a directional coupler 206 and fed back to the APC loop 201 by a wideband detector diode 208, is fed to the gain control input port of a variable-gain power amplifier 205 controlling the power level $P_{out}$ of the RF output signal $x(t)$ |
| 201E | APC loop of a QAM transmitter 200b according to one embodiment of the present invention (cf. Fig. 2b) for stabilizing the output power $P_{out}$ of an RF signal to be transmitted, characterized in that the output signal of a comparator stage 212 supplied with a reference signal $V_{ref}$ representing the nominal power level $P_{ref}$ for the desired output power level $P_{out}$ of the RF output signal $x(t)$ and the actual output power level $P_{out}$, supplied by a directional coupler 206 and fed back to the APC loop 201E by a wideband detector diode 208, is fed to the control input port of an electronically controllable attenuator 203 controlling the power level $P_{out}$ of the RF output signal $x(t)$ |
| 201S | APC loop of a QAM transmitter 200a according to the state of the art (cf. Fig. 2a), that is used for stabilizing the power level $P_{out}$ at the output port of the RF signal generator 200a, characterized in that the output signal of a comparator stage 212' supplied with a reference signal $V_{ref}$ representing the nominal power level $P_{ref}$ for the desired output power level $P_{out}$ of the RF output signal $x(t)$ and the actual output power level $P_{out}$, supplied by a directional coupler 206' and fed back to the APC loop 201S by a wideband detector diode 208', is fed to the control input port of an electronically controllable attenuator 203' controlling the power level $P_{out}$ of the RF output signal $x(t)$ |

(continued)

| No. | System Component or Procedure Step |
|---|---|
| 202 | local oscillator (LO) of the modulator stages 204 and 204E of the QAM transmitters 200 and 200b, respectively, which provides a sinusoidal oscillator signal $c(t)$ with a tunable frequency |
| 202' | local oscillator (LO) of the RF signal generator 200a, which provides the amplitude modulator stage 203' with a sinusoidal oscillator signal $c(t)$ |
| 203 | voltage-controlled attenuator (VCA) in the modulator stage 204E of the QAM transmitter 200b, which is used for attenuating the power level $P_c$ of the oscillator signal supplied by the local oscillator 202 of the modulator stage 204E |
| 203' | electronically controllable attenuator of the RF signal generator 200a, e.g. an amplitude modulator stage comprising current-controlled PIN diodes realizing a tunable resistor with hybrid microwave integrated circuit (MIC) technology, which is used for attenuating the power level $P_c$ of the oscillator signal supplied by the local oscillator 202' |
| 204 | modulator stage of the QAM transmitter 200, comprising two up-conversion mixers 204a+b, driven by the local oscillator 202, for directly up-converting the in-phase (I) and quadrature (Q) signal of a signal to be transmitted from the baseband to an RF band, a 90-degree phase shifter 204c, connected to one input port of the up-conversion mixer 204a, and a summation element 204d for combining the RF output signals of the two up-conversion mixers 204a and 204b |
| 204E | modulator stage of the QAM transmitter 200b, comprising two up-conversion mixers 204a+b, driven by the local oscillator 202, for directly up-converting the in-phase (I) and quadrature (Q) signal of a signal to be transmitted from the baseband to an RF band, a 90-degree phase shifter 204c, connected to one input port of the up-conversion mixer 204a, a summation element 204d for combining the RF output signals of the two up-conversion mixers 204a and 204b, and a voltage-controlled attenuator 203 (VCA) for attenuating the power level $P_c$ of the oscillator signal supplied by the local oscillator 202 of the modulator stage 204E |
| 204a | 1st up-conversion mixer of the modulation stages 204 and 204E, respectively, driven by the local oscillator 202, for directly up-converting the quadrature (Q) signal of a signal to be transmitted from the baseband to an RF band |
| 204b | 2nd up-conversion mixer of the modulation stages 204 and 204E, respectively, driven by the local oscillator 202, for directly up-converting the in-phase (I) signal of a signal to be transmitted from the baseband to an RF band |
| 204c | 90-degree phase shifter (Hilbert transformer) of the modulation stages 204 and 204E, respectively, connected to one input port of the up-conversion mixer 204a |
| 204d | summation element of the modulator stages 204 and 204E, respectively, for combining the RF output signals of the two up-conversion mixers 204a and 204b |
| 205 | variable-gain power amplifier (PA) controlling the power level $P_{out}$ of the RF output signal of the QAM transmitters 200 and 200b, respectively, whose gain $G_{PA}$ is either controlled by the output signal of the comparator stage 212 (cf. Fig. 2) or by means of an external PA control signal (cf. Fig. 2b) |
| 206 | directional coupler in the APC loops 201 and 201E of the QAM transmitters 200 and 200b, respectively, which provides the APC loop 201 (201E) with the extracted feed-back signal (the reflected wave of the RF signal to be transmitted) |
| 206' | directional coupler in the APC loop 201S of the QAM transmitter 200a, which provides the APC loop 200a with the extracted feedback signal (the reflected wave of the RF signal to be transmitted) |
| 208 | wideband detector diode in the feedback chain of the APC loops 201 and 201E, respectively, for detecting the actual power level $P_{out}$ of said feedback signal |

(continued)

| No. | System Component or Procedure Step |
|---|---|
| 208’ | wideband detector diode in the feedback chain of the APC loop 201S for detecting the actual power level $P_{out}$ of said feedback signal |
| 208" | external automatic power control (APC) detector (not shown) for detecting the actual power level $P_{out}$ of said feedback signal |
| 209’ | controllable current source of the RF signal generator 200a for generating a current $I_G$ whose strength is direct proportional to the nominal value $P_{ref}$ of the desired output power level $P_{out}$ |
| 210 | transmit (Tx) antenna of the QAM transmitter 200 (200b) |
| 212 | comparator stage of the QAM transmitter 200 (200b), supplied with a reference signal $V_{ref}$ representing the nominal power level $P_{ref}$ for the desired output power level $P_{out}$ of the RF output signal and the actual output power level $P_{out}$ fed back to the APC loop 201 or 201E, respectively, by the wideband detector diode 208, whose output signal is either fed to the gain control input port of the power amplifier 205 (cf. Fig. 2) or an electronically controllable attenuator 203, respectively (cf. Fig. 2b) |
| 212’ | comparator stage of the APC loop of the RF signal generator 200a, supplied with a reference signal $V_{ref}$ representing the nominal power level $P_{ref}$ for the desired output power level $P_{out}$ of the RF output signal and the actual output power level $P_{out}$ fed back to the APC loop 201S by the wideband detector diode 208’, whose output signal is fed to the control input port of an electronically controllable attenuator 203’ (cf. Fig. 2a) |
| 214a’ | input port of the RF signal generator 200a for the external APC detector 208" |
| 214b’ | RF output port of the RF signal generator 200a |
| 300a | schematic diagram showing the typical structure of a TDMA frame with eight time slots, each having a slot length of 156.25 bit and a burst length of 148 bit, which is used in a TDMA-based communication system |
| 300b | diagram showing the burst profile of the RF output power $P_{out}$ of a transmitted signal stream in the uplink of a TDMA-based communication system over the time t, wherein the output power of a wireless RF transmitter 200 (200a, 200b) has to be ramped up to an appropriate level or ramped down to zero between adjacent time slots $TS_i$ and $TS_j$ (with $i \in \{0, 1, 2,..., 7\}$ and $j := (i+1)\ mod\ 8$) such that the output power level $P_{out}$ is constant during transmission in order to facilitate time-division multiplexing between different TDMA channels |
| 400 | flow chart illustrating a method for stabilizing the power level $P_{out}$ of a modulated RF signal $x(t)$ to be transmitted by the QAM transmitter 200b of a wireless communication device according to the present invention |
| *S* | switch for selectively choosing an internal APC detector 208’ or an external APC detector 208" |
| S0 | step #0: adjusting the actual power level $P_{out}$ by controlling the attenuation factor $a$ of a voltage-controlled attenuator 203 in the modulator stage 204E of the QAM transmitter 200b, which is used for attenuating the power level $P_c$ of the sinusoidal oscillator signal $c(t)$ supplied by the local oscillator 202 of the modulator stage 204E |
| S1 | step # 1: detecting the actual power level $P_{out}$ of the RF output signal $x(t)$ |
| S2 | step #2: feeding back said actual power level $P_{out}$ to a first input port of the comparator stage 212 in the feedback chain of the automatic power control loop 201E |

(continued)

| No. | System Component or Procedure Step |
|---|---|
| S3 | step #3: comparing said actual power level $P_{out}$ with a reference signal $V_{ref}$ representing the nominal power level $P_{ref}$ for the desired output power level $P_{out}$ of the RF output signal fed to a second input port of the comparator stage 212 |
| S4 | step #4: compensating instabilities of the RF output power $P_{out}$ by controlling the attenuation factor *a* of a voltage-controlled attenuator 203 based on magnitude and sign of the difference between the actual power level $P_{out}$ and the nominal power level $P_{ref}$ |
| S1' | step #1': accessing a data base stored in a read-only memory integrated in the wireless communication device which holds information about device-specific hardware tolerances, influences caused by temperature drifts $dT/dt$ and battery voltage drifts $dU_{batt}/dt$ |
| S2' | step #2': compensating instabilities of the RF output power ($P_{out}$) based on this information |
| S1" | step #1": measuring the DC supply current $I_{PA}$ of the power amplifier 205 by sensing a voltage drop $U_{RM}$ proportional the supply current $I_{PA}$ at a low-ohm resistor $R_M$ placed in the power supply line of the power amplifier 205 |
| S2" | step #2": feeding this voltage $U_{RM}$ to a first input port of the comparator stage 212 in the feedback chain of the automatic power control loop 201E |
| S3" | step #3": comparing S3" the sensed voltage $U_{RM}$ with a reference signal $V_{ref}$ representing the nominal power level $P_{ref}$ for the desired output power level $P_{out}$ of the RF output signal *x(t)* fed to a second input port of the comparator stage 212 |
| S4" | step #4" compensating instabilities of the RF output power $P_{out}$ by controlling the attenuation factor *a* of a voltage-controlled attenuator 203 based on magnitude and sign of the difference between the sensed voltage $U_{RM}$ and the reference signal $V_{ref}$ |
| S5 | step #5: adjusting the gain factor $G_{PA}$ of the power amplifier 205 by means of an external power amplifier control signal (PA control) |

**Claims**

**1.** A QAM transmitter of a wireless communication device in a cellular network environment based on time-division multiplexing (TDM), wherein each QAM channel in upstream direction is subdivided into a predefined number of time-division multiple access (TDMA) channels and each mobile terminal ($MT_i$) participating in communication with a base station (BS) is allocated to a periodically repeated time slot ($TS_i$), the QAM transmitter (200b) comprising

- a modulator stage (204E) consisting of two up-conversion mixers (204a, 204b) driven by a local oscillator (202) for directly up-converting an in-phase (I) signal and a quadrature (Q) signal of a complex-valued analog baseband signal ($x_{LP}(t)$) from the baseband to an RF band, a 90-degree phase shifter (204c) connected to an LO input port of one of these up-conversion mixers (204a) in a quadrature chain of said modulator stage (204E) and a summation element (204d) for combining the RF output signals of the up-conversion mixers (204a+b),
- a variable-gain power amplifier (205) post-connected to the summation element (204d), and
- an automatic power control circuitry (201 E) for stabilizing the power level ($P_{out}$) of the RF signal ($x(t)$) to be transmitted at the output port of said power amplifier (205), said circuitry (201 E) comprising a comparator stage (212) supplied with a reference signal ($V_{ref}$) representing a nominal power level ($P_{ref}$) for a desired power level ($P_{out}$) of the RF signal ($x(t)$)and with a feedback signal (FS) which represents an actual power level ($P_{out}$) of said RF signal ($x(t)$),

**characterized by**
a voltage-controlled attenuator (203) placed in the modulator stage (204E) for attenuating the power level ($P_c$) of an approximately sinusoidal oscillator signal ($c(t)$) supplied by the local oscillator (202) that is used by said up-conversion mixers (204a, 204b) for directly up-converting the in-phase (I) and the quadrature (Q) signal, thereby attenuating the power level ($P_{out}$) of the RF signal ($x(t)$), wherein a control input port of said voltage-controlled attenuator (203) is connected to an output port of said comparator stage (212).

**2.** A QAM transmitter according to claim 1,
**characterized in that**
said automatic power control circuitry (201E) is realized as a closed-loop circuitry, wherein the detected signal amplitude of the RF signal ($x(t)$) to be transmitted is used as said feedback signal (FS).

**3.** A QAM transmitter according to claim 1,
**characterized in that**
said automatic power control circuitry (201E) is realized as a closed-loop circuitry, wherein the supply current ($I_{PA}$) of a power amplifier (205) integrated in the QAM transmitter (200b) is used as said feedback signal (FS).

**4.** A method for stabilizing the power level ($P_{out}$) of a modulated RF signal ($x(t)$) to be transmitted at the output port of a variable-gain power amplifier (205) integrated in a QAM transmitter (200b) of a wireless communication device, said method being performed during a burst period ($T_{Burst}$) of a periodically repeated time slot ($TS_i$) allocated to the wireless communication device, the method comprising the steps of

- detecting (S1) an actual power level ($P_{out}$) of the RF signal ($x(t)$),
- feeding back (S2) said actual power level ($P_{out}$) to a first input port of a comparator stage (212) in a feedback chain of an automatic power control loop (201E),
- comparing (S3) said actual power level ($P_{out}$) with a reference signal ($V_{ref}$) representing a nominal power level ($P_{ref}$) for a desired output power level ($P_{out}$) of the RF signal ($x(t)$) fed to a second input port of the comparator stage (212), and
- compensating (S4) instabilities of the RF output power ($P_{out}$) based on magnitude and sign of the difference between the actual power level ($P_{out}$) and the nominal power level ($P_{ref}$),

**characterized in that**
said step of compensating (S4) instabilities of the RF output power ($P_{out}$) is performed by controlling an attenuation factor ($a$) of a voltage-controlled attenuator (203) to adjust (S0) an actual value of the power level ($P_{out}$), wherein said voltage-controlled attenuator (203) is integrated in a modulator stage (204E) of the QAM transmitter (200b) and used for attenuating the power level ($P_c$) of an approximately sinusoidal oscillator signal ($c(t)$) supplied by a local oscillator (202) integrated in said modulator stage (204E).

**5.** A method according to claim 4,
**characterized by** the following steps:

- measuring (S1") a DC supply current ($Ip_A$) of the power amplifier (205) by sensing a voltage drop ($U_{RM}$) proportional to said supply current ($I_{PA}$) at a low-ohm resistor ($R_M$) placed in a power supply line of the power amplifier (205),
- feeding (S2'') this voltage ($U_{RM}$) to a first input port of the comparator stage (212) in the feedback chain of the automatic power control loop (201E),
- comparing (S3'') the sensed voltage ($U_{RM}$) with a reference signal ($V_{ref}$) representing the nominal power level ($P_{ref}$) for the desired output power level ($P_{out}$) of the RF signal *(x(t))* fed to a second input port of the comparator stage (212), and
- compensating (S4") instabilities of the RF output power ($P_{out}$) by controlling the attenuation factor ($a$) of a voltage-controlled attenuator (203) based on magnitude and sign of the difference between the sensed voltage ($U_{RM}$) and the reference signal ($V_{ref}$).

**6.** A method according to anyone of the claims 4 to 5,
**characterized by** the step of
adjusting (S5) the gain factor ($G_{PA}$) of the power amplifier (205) by means of an external power amplifier control signal (PA control).

**7.** A method according to claim 6,
**characterized in that**
the gain factor ($G_{PA}$) of the power amplifier (205) is set to its maximum value within a burst period ($T_{Burst}$) of a periodically repeated time slot ($TS_i$) and set to zero outside said burst period ($T_{Burst}$) to improve adjacent channel isolation.

8. A wireless communication device in a cellular network environment based on time-division multiplexing (TDM), wherein each QAM channel in upstream direction is subdivided into a predefined number of time-division multiple access (TDMA) channels and each mobile terminal ($MT_i$) participating in communication with a base station (BS) is allocated to a periodically repeated time slot ($TS_i$) of a predefined length ($T_{TS}$),
**characterized by**
a QAM transmitter (200b) according to anyone of the claims 1 to 3.

**Patentansprüche**

1. QAM-Sender einer drahtlosen Kommunikationsvorrichtung in einer zellularen Netzwerkumgebung auf einer Zeitmultiplex-(TDM)-Basis, wobei jeder QAM-Kanal in Aufwärtsrichtung in eine zuvor festgelegte Anzahl von Zeitmultiplex-Vielfachzugriffs-(TDMA)-Kanälen unterteil ist und wobei jedem mobilen Endgerät ($MT_i$), welches an einer Kommunikation mit einer Basisstation (BS) teilnimmt, ein periodisch wiederholter Zeitschlitz ($TS_i$) zugeteilt ist, wobei der QAM-Sender (200b) umfasst

- eine Modulatorstufe (204E), bestehend aus zwei Aufwärtsmischern (204a, 204b), die durch einen lokalen Oszillator (202) für eine direkte Aufwärtsmischung eines In-Phase-(I)-Signals und eines Quadratur-(Q)-Signals eines einen komplexen Wert aufweisenden analogen Basisbandsignals ($x_{LP}$)(t)) aus dem Basisband in ein HF-Band gesteuert werden, einem 90-Grad-Phasenschieber (204c), der mit einem LO-Eingangsanschluss eines dieser Aufwärtsmischer (204a) in einer Quadraturkette der genannten Modulatorstufe (204E) verbunden ist, und einem Summierelement (204d) zum Kombinieren der HF-Ausgangssignale der Aufwärtsmischer (204a+b),
- einen Leistungsverstärker (205) mit veränderbarer Verstärkung, der dem Summierelement (204d) nachgeschaltet ist,
- und eine automatische Leistungssteuerschaltung (201E) zur Stabilisierung des Leistungspegels ($P_{out}$) des am Ausgangsanschluss des genannten Leistungsverstärkers (205) zu übertragenden HF-Signals (x(t)), wobei die betreffende Schaltung (201E) eine Komparatorstufe (212) umfasst, der ein Referenzsignal ($V_{ref}$), welches einen Nennleistungspegel ($P_{ref}$) für einen gewünschten Leistungspegel ($P_{out}$) des HF-Signals (x(t)) darstellt, und ein Rückkopplungssignal (FS) zugeführt werden, welches einen Istleistungspegel ($P_{out}$) des betreffenden HF-Signals (x(t)) darstellt,

**dadurch gekennzeichnet, dass** in der Modulatorstufe (204E) ein spannungsgesteuertes Dämpfungsglied (203) zur Bedämpfung des Leistungspegels ($P_c$) eines durch den lokalen Oszillator (202) gelieferten, etwa sinusförmigen Oszillatorsignals (c(t)) untergebracht ist, welches von den genannten Aufwärtsmischern (204a, 204b) zur direkten Aufwärtsmischung des In-Phase-(I)- und des Quadratur-(Q)-Signals herangezogen wird, derart, dass dadurch der Leistungspegel ($P_{out}$) des HF-Signals (x(t)) bedämpft wird, wobei ein Steuereingangsanschluss des betreffenden spannungsgesteuerten Dämpfungsgliedes (203) mit einem Ausgangsanschluss der genannten Komparatorstufe (212) verbunden ist.

2. QAM-Sender nach Anspruch 1, **dadurch gekennzeichnet, dass** die genannte automatische Leistungssteuerschaltung (201E) als geschlossene Schleifenschaltung realisiert ist, wobei die ermittelte Signalamplitude des zu übertragenden HF-Signals (x(t)) als das genannte Rückkopplungssignal (FS) herangezogen wird.

3. QAM-Sender nach Anspruch 1, **dadurch gekennzeichnet, dass** die genannte automatische Leistungssteuerschaltung (201E) als geschlossene Schleifenschaltung realisiert ist, wobei der Abgabestrom ($I_{PA}$) eines in dem QAM-Sender (200b) integrierten Leistungsverstärkers (205) als das genannte Rückkopplungssignal (FS) herangezogen wird.

4. Verfahren zur Stabilisierung des Leistungspegels ($P_{out}$) eines am Ausgangsanschluss eines in einem QAM-Sender (200b) einer drahtlosen Kommunikationsvorrichtung integrierten Leistungsverstärkers (205) mit veränderbarer Verstärkung zu übertragenden modulierten HF-Signals (x(t)), wobei das betreffende Verfahren während einer Burst-Zeitspanne ($T_{Burst}$) eines periodisch wiederholten Zeitschlitzes ($TS_i$) ausgeführt wird, der der drahtlosen Kommunikationsvorrichtung zugeteilt ist, umfassend die Verfahrensschritte Detektieren (S1) eines Istleistungspegels ($P_{out}$) des HF-Signals (x(t)), Rückkoppeln (S2) des genannten Istleistungspegels ($P_{out}$) zu einem ersten Eingangsanschluss einer Komparatorstufe (212) in einer Rückkopplungskette eines automatischen Leistungssteuerkreises (201E),

Vergleichen (S3) des betreffenden Istleistungspegels ($P_{out}$) mit einem einen Nennleistungspegel ($P_{ref}$) für einen gewünschten Ausgangsleistungspegel ($P_{out}$) des HF-Signals (x(t)) darstellenden Referenzsignal ($V_{ref}$), welches einem zweiten Eingangsanschluss der Komparatorstufe (212) zugeführt wird,
und Kompensieren (S4) von Instabilitäten der HF-Ausgangsleistung ($P_{out}$) auf der Grundlage der Größe und des Vorzeichens der Differenz zwischen dem Istleistungspegel ($P_{out}$) und dem Nennleistungspegel ($P_{ref}$),
**dadurch gekennzeichnet,**
**dass** der Instabilitäten der HF-Ausgangsleitung ($P_{out}$) kompensierende Schritt (S4) dadurch ausgeführt wird, dass ein Dämpfungsfaktor (a) eines spannungsgesteuerten Dämpfungsgliedes (203) derart gesteuert wird, dass ein Istwert des Leistungspegels ($P_{out}$) eingestellt (S0) wird,
wobei das betreffende spannungsgesteuerte Dämpfungsglied (203) in einer Modulatorstufe (204E) des QAM-Senders (200b) integriert ist und zur Bedämpfung des Leistungspegels ($P_c$) eines etwa sinusförmigen Oszillatorsignals (c(t)) herangezogen wird, welches von einem in der genannten Modulatorstufe (204E) integrierten lokalen Oszillator (202) geliefert wird.

**5.** Verfahren nach Anspruch 4, **gekennzeichnet durch** folgende Schritte:

- Messen (S1") eines Abgabegleichstroms ($I_{PA}$) des Leistungsverstärkers (205) durch Ermitteln eines dem betreffenden Abgabestrom ($I_{PA}$) proportionalen Spannungsabfalls ($U_{RM}$) an einem niederohmigen Widerstand ($R_M$), der in einer Spannungsversorgungsleitung des Leitungsverstärkers (205) untergebracht ist,
- Zuführen (S2") dieser Spannung ($U_{RM}$) zu einem ersten Eingangsanschluss der Komparatorstufe (212) in der Rückkopplungskette des automatischen Leistungssteuerkreises (201E),
- Vergleichen (S3") der ermittelten Spannung ($U_{RM}$) mit einem einem zweiten Eingangsanschluss der Komparatorstufe (212) zugeführten, den Nennleistungspegel ($P_{ref}$) für den gewünschten Ausgangsleistungspegel ($P_{out}$) des HF-Signals (x(t)) darstellenden Referenzsignal ($V_{ref}$)
- und Kompensieren (S4") von Instabilitäten der HF-Ausgangsleistung ($P_{out}$) durch Steuern des Dämpfungsfaktors (a) des spannungsgesteuerten Dämpfungsgliedes (203) auf der Grundlage der Größe und des Vorzeichens der Differenz zwischen der ermittelten Spannung ($U_{RM}$) und dem Referenzsignal ($V_{ref}$).

**6.** Verfahren nach Anspruch 4 oder 5, **gekennzeichnet durch** den Schritt des Einstellens (S5) des Verstärkungsfaktors ($G_{PA}$) des Leistungsverstärkers (205) mittels eines externen Leistungsverstärker-Steuersignals (PA-Steuerung).

**7.** Verfahren nach Anspruch 6, **dadurch gekennzeichnet, dass** der Verstärkungsfaktor ($G_{PA}$) des Leistungsverstärkers (205) zur Verbesserung der Nachbarkanaltrennung innerhalb einer Burst-Zeitspanne ($T_{Burst}$) eines periodisch wiederholten Zeitschlitzes ($TS_i$) auf seinen Maximalwert und außerhalb der betreffenden Burst-Zeitspanne ($T_{Burst}$) auf Null festgelegt ist.

**8.** Drahtlose Kommunikationsvorrichtung in einer zellularen Netzwerkumgebung auf Zeitmultiplexbasis (TDM), wobei jeder QAM-Kanal in einer Aufwärtsrichtung in eine zuvor festgelegte Anzahl von Zeitmultiplex-Vielfachzugriffs-(TDMA)-Kanälen unterteilt ist und wobei jedem mobilen Endgerät ($MT_i$), welches an einer Kommunikation mit einer Basisstation (BS) teilnimmt, ein periodisch.wiederholter Zeitschlitz ($TS_i$) einer zuvor festgelegten Länge ($T_{TS}$) zugeteilt ist, **gekennzeichnet durch** einen QAM-Sender (200b) nach einem der Ansprüche 1 bis 3.

## Revendications

**1.** Emetteur à modulation d'amplitude en quadrature (QAM pour *Quadrature Amplitude Modulation*) d'un dispositif de communications sans fil dans un environnement de réseau cellulaire basé sur le multiplexage par répartition dans le temps (TDM pour *Time Division Multiplexing*), dans lequel chaque canal QAM dans le sens montant est subdivisé en un nombre prédéfini de canaux à accès multiple par répartition dans le temps (TDMA pour Time Division Multiplex Access) et chaque terminal mobile ($MT_i$, MT pour *Mobile Terminal*) participant à la communication avec une station de base (BS pour *Basis Station*) est affecté à un intervalle de temps répété périodiquement ($TS_i$, TS pour *Time Slot*), l'émetteur QAM (200b) comprenant :

- un étage de modulateur (204E) se composant de deux mélangeurs élévateurs de fréquence (204a, 204b) pilotés par un oscillateur local (202) servant à transposer directement en fréquence, de la bande de base sur une bande RF, un signal en phase (I) et un signal en quadrature (Q) d'un signal en bande de base analogique à valeur complexe ($x_{LP}(t)$), d'un déphaseur à 90 degrés (204c) connecté à un port d'entrée LO de l'un de ces mélangeurs élévateurs de fréquence (204a) dans une chaîne en quadrature dudit étage de modulateur (204E) et d'un élément de sommation (204d) servant à combiner les signaux de sortie RF des mélangeurs élévateurs de fréquence (204a+b),

- un amplificateur de puissance à gain variable (205) connecté après l'élément de sommation (204d), et
- un circuit de commande de puissance automatique (201E) servant à stabiliser le niveau de puissance ($P_{out}$) du signal RF (*x(t)*) à transmettre au port de sortie dudit amplificateur de puissance (205), ledit circuit (201E) comprenant un étage de comparateur (212) qui reçoit un signal de référence ($V_{ref}$) représentant un niveau de puissance nominal ($P_{ref}$) pour un niveau de puissance souhaité ($P_{out}$) du signal RF (*x(t)*) et un signal de retour (FS pour *Feedback Signal*) qui représente un niveau de puissance effectif ($P_{out}$) dudit signal RF (*x(t)*),

**caractérisé par**
un atténuateur commandé en tension (203) placé dans l'étage de modulateur (204E) pour atténuer le niveau de puissance ($P_c$) d'un signal d'oscillateur approximativement sinusoïdal (*c(t)*) délivré par l'oscillateur local (202) qui est utilisé par lesdits mélangeurs élévateurs de fréquence (204a, 204b) pour la transposition directe en fréquence du signal en phase (I) et du signal en quadrature (Q), atténuant de ce fait le niveau de puissance ($P_{out}$) du signal RF (*x(t)*), dans lequel un port d'entrée de commande dudit atténuateur commandé en tension (203) est connecté à un port de sortie dudit étage de comparateur (212).

2. Emetteur QAM selon la revendication 1, **caractérisé en ce que** ledit circuit de commande de puissance automatique (201E) est réalisé sous la forme d'un circuit en bouclé fermée, dans lequel l'amplitude de signal détectée du signal RF (*x(t)*) à transmettre est utilisée comme étant ledit signal de retour (FS).

3. Emetteur QAM selon la revendication 1, **caractérisé en ce que** ledit circuit de commande de puissance automatique (201E) est réalisé sous la forme d'un circuit en bouclé fermée, dans lequel le courant d'alimentation ($I_{PA}$) d'un amplificateur de puissance (205) intégré dans l'émetteur QAM (200b) est utilisé comme étant ledit signal de retour (FS).

4. Procédé de stabilisation du niveau de puissance ($P_{out}$) d'un signal RF modulé (*x*(*t*)) à transmettre au port de sortie d'un amplificateur de puissance à gain variable (205) intégré dans un émetteur QAM (200b) d'un dispositif de communications sans fil, ledit procédé étant exécuté pendant une période de salves ($T_{Burst}$) d'un intervalle de temps répété périodiquement ($TS_i$) alloué au dispositif de communications sans fil, le procédé comprenant les étapes qui consistent à :

   - détecter (S1) un niveau de puissance effectif ($P_{out}$) du signal RF (*x(t)*),
   - retourner (S2) ledit niveau de puissance effectif ($P_{out}$) à un premier port d'entrée d'un étage de comparateur (212) dans une chaîne de retour d'une boucle de commande de puissance automatique (201E),
   - comparer (S3) ledit niveau de puissance effectif ($P_{out}$) à un signal de référence ($V_{ref}$) représentant un niveau de puissance nominal ($P_{ref}$) pour un niveau de puissance de sortie souhaité ($P_{out}$) du signal RF (*x*(*t*)) délivré à un deuxième port d'entrée de l'étage de comparateur (212), et
   - compenser (S4) les instabilités de la puissance de sortie RF ($P_{out}$) sur la base de l'amplitude et du signe de la différence entre le niveau de puissance effectif ($P_{out}$) et le niveau de puissance nominal ($P_{ref}$),

   **caractérisé en ce que** ladite étape de compensation (S4) des instabilités de la puissance de sortie RF ($P_{out}$) est exécutée en commandant un facteur d'atténuation (a) d'un atténuateur commandé en tension (203) pour régler (S0) une valeur effective du niveau de puissance ($P_{out}$), dans lequel ledit atténuateur commandé en tension (203) est intégré dans un étage de modulateur (204E) de l'émetteur QAM (200b) et est utilisé pour atténuer le niveau de puissance ($P_c$) d'un signal d'oscillateur approximativement sinusoïdal (*c(t)*) délivré par un oscillateur local (202) intégré dans ledit étage de modulateur (204E).

5. Procédé selon la revendication 4, **caractérisé par** les étapes qui consistent à :

   - mesurer (S1") un courant d'alimentation c.c. ($I_{PA}$) de l'amplificateur de puissance (205) en détectant une chute de tension ($U_{RM}$) proportionnelle audit courant d'alimentation ($I_{PA}$) sur une résistance à basse impédance ($R_M$) placée sur une ligne d'alimentation électrique de l'amplificateur de puissance (205),
   - délivrer (S2") cette tension ($U_{RM}$) à un premier port d'entrée de l'étage de comparateur (212) dans la chaîne de retour de la boucle de commande de puissance automatique (201E),
   - comparer (S3") la tension détectée ($U_{RM}$) à un signal de référence ($V_{ref}$) représentant le niveau de puissance nominal ($P_{ref}$) pour le niveau de puissance de sortie souhaité ($P_{out}$) du signal RF (*x(t)*) délivré à un deuxième port d'entrée de l'étage de comparateur (212), et

- compenser (S4") les instabilités de la puissance de sortie RF ($P_{out}$) en commandant un facteur d'atténuation (a) d'un atténuateur commandé en tension (203) sur la base de l'amplitude et du signe de la différence entre la tension détectée ($U_{RM}$) et le signal de référence ($V_{ref}$).

**6.** Procédé selon l'une quelconque des revendications 4 à 5, **caractérisé par** l'étape qui consiste à :

régler (S5) le facteur de gain ($G_{PA}$) de l'amplificateur de puissance (205) au moyen d'un signal de commande d'amplificateur de puissance externe (commande de l'amplificateur de puissance).

**7.** Procédé selon la revendication 6, **caractérisé en ce que** le facteur de gain ($G_{PA}$) de l'amplificateur de puissance (205) est réglé à sa valeur maximale à l'intérieur d'une période de salves ($T_{Burst}$) d'un intervalle de temps répété périodiquement ($TS_i$) et qu'il est réglé à zéro en dehors de ladite période de salves ($T_{Burst}$) pour améliorer l'isolation entre canaux adjacents.

**8.** Dispositif de communications sans fil dans un environnement de réseau cellulaire basé sur le multiplexage par répartition dans le temps (TDM), dans lequel chaque canal QAM dans le sens montant est subdivisé en un nombre prédéfini de canaux à accès multiple par répartition dans le temps (TDMA) et chaque terminal mobile ($MT_i$) participant à la communication avec une station de base (BS) est affecté à un intervalle de temps répété périodiquement ($TS_i$) d'une longueur prédéfinie ($T_{TS}$), **caractérisé par :**

un émetteur QAM (200 b) selon l'une quelconque des revendications 1 à 3.

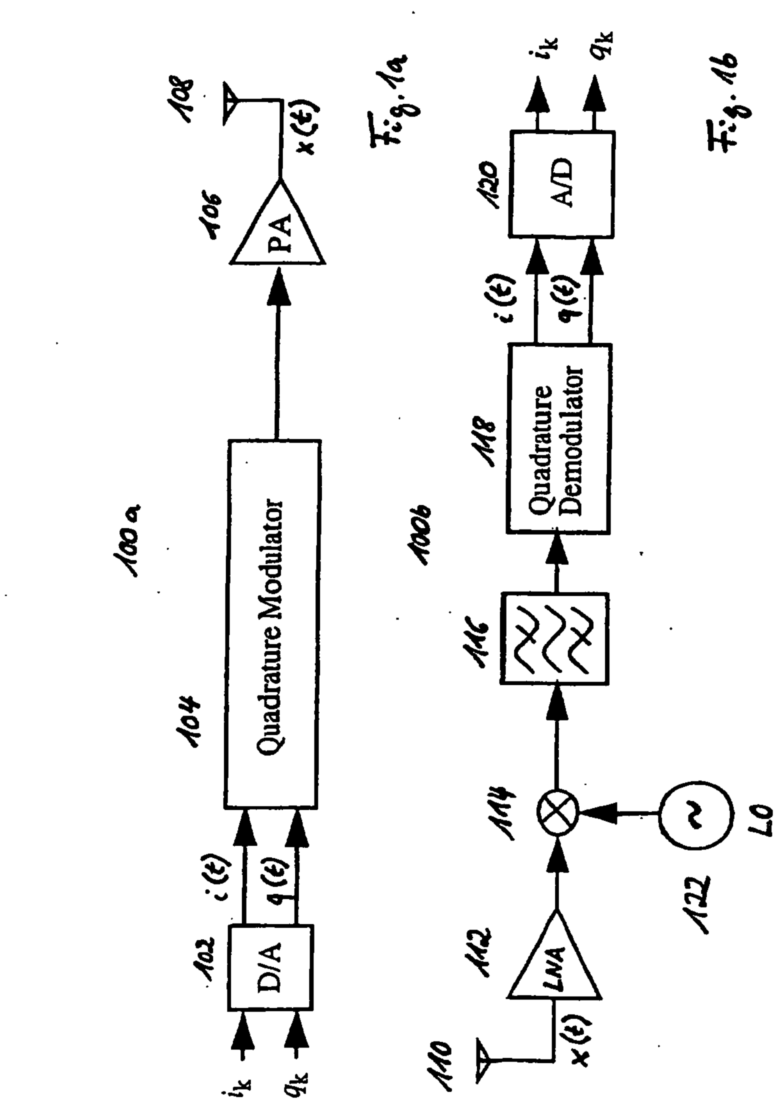
100a
$i_k$
$q_k$
102
D/A
i(t)
q(t)
104
Quadrature Modulator
106
PA
108
x(t)
100b
110
x(t)
112
LNA
114
122
LO
116
118
Quadrature Demodulator
i(t)
q(t)
120
A/D
$i_k$
$q_k$

Fig. 1a

Fig. 1b

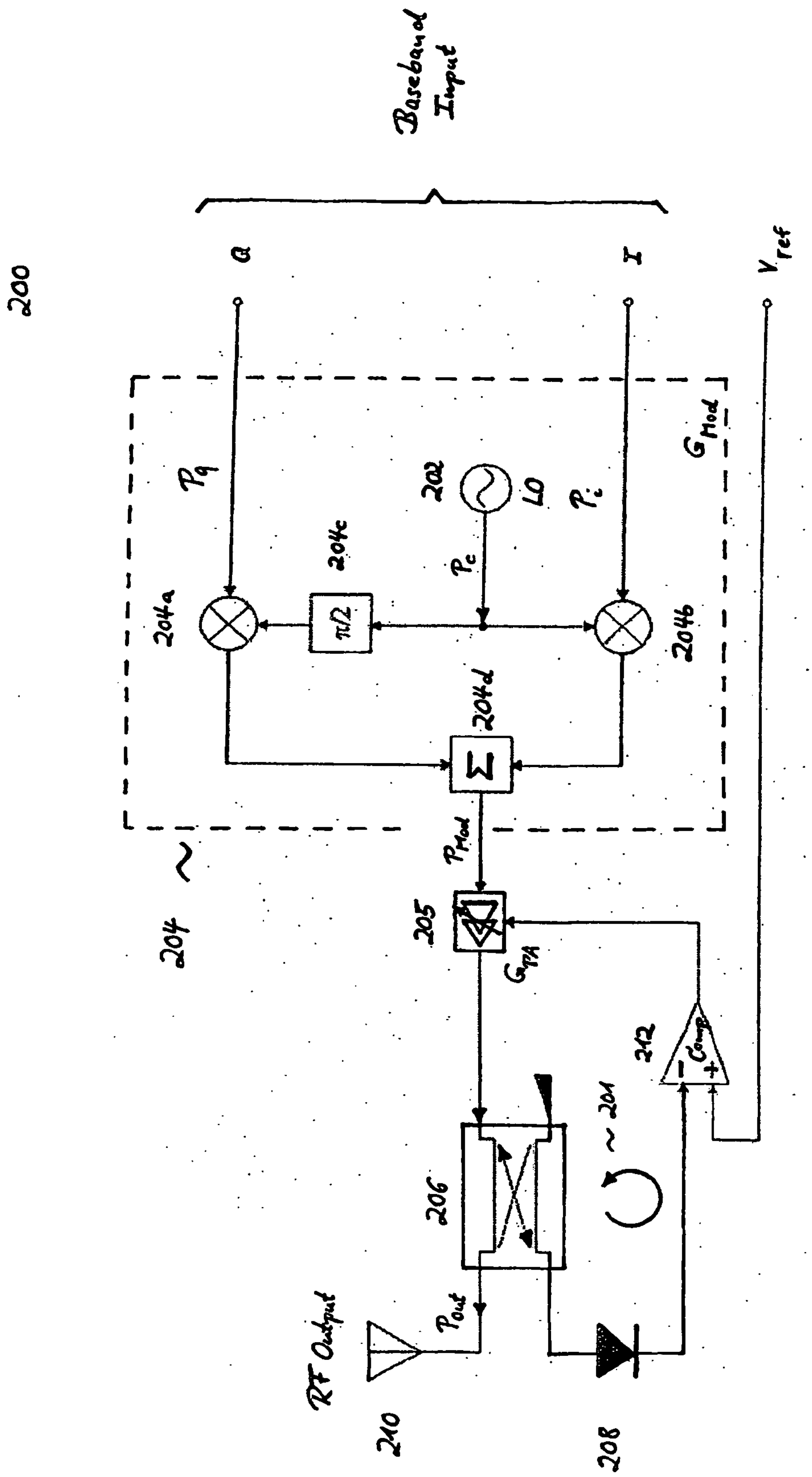
200
Baseband Input
Q
I
$V_{ref}$
$P_q$
$P_i$
202
LO
$P_c$
204c
$\pi/2$
204a
204b
204d
$\Sigma$
$G_{Mod}$
$P_{Mod}$
204
205
$G_{TA}$
212
$Comp$
− +
~ 201
206
$P_{out}$
RF Output
210
208

Fig. 2

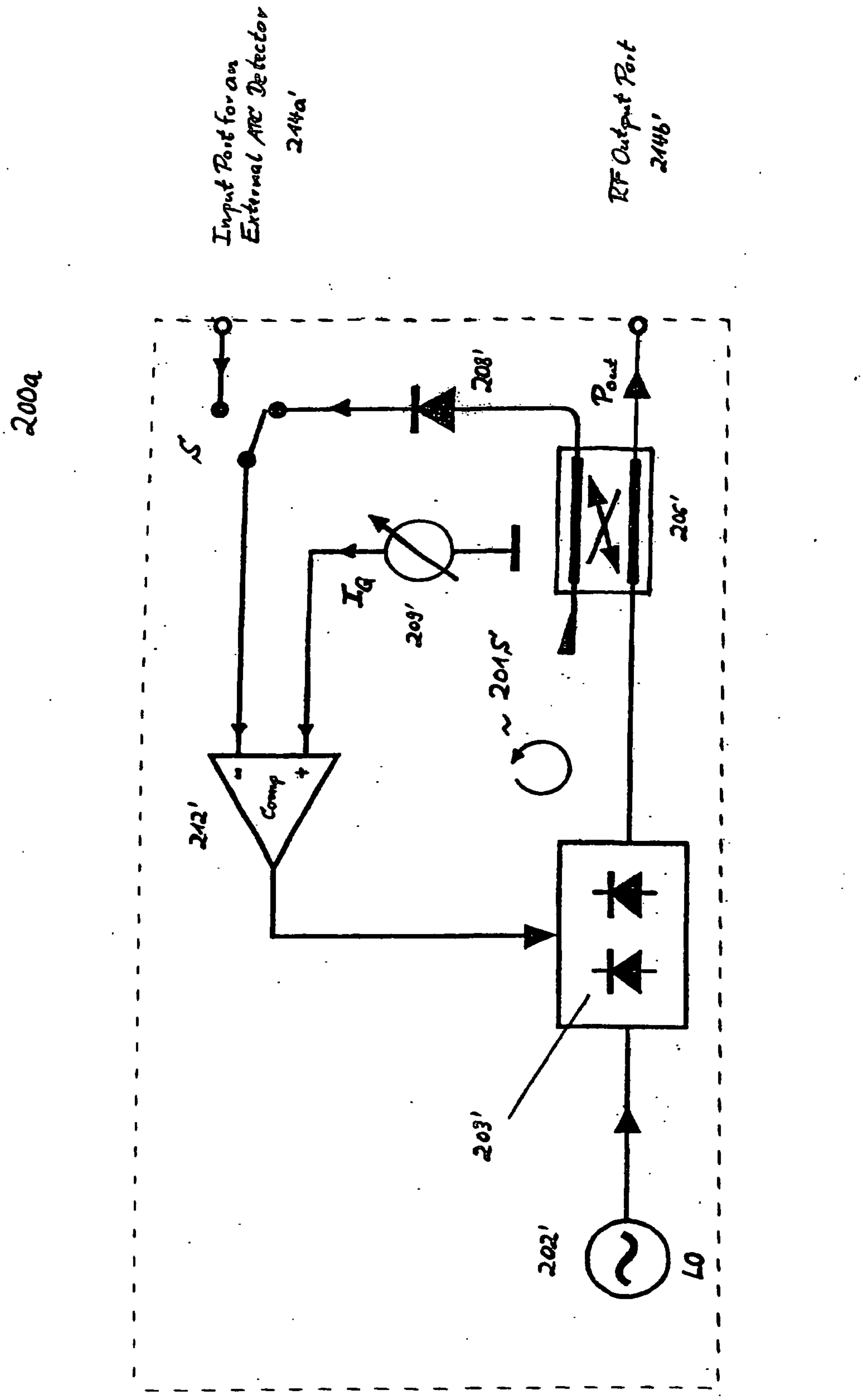
200a
Input Port for an External AFC Detector
214a'
RF Output Port
214b'
S
208'
Pout
206'
IG
209'
~ 201S
212'
Comp
203'
202'
LO

Fig. 2a

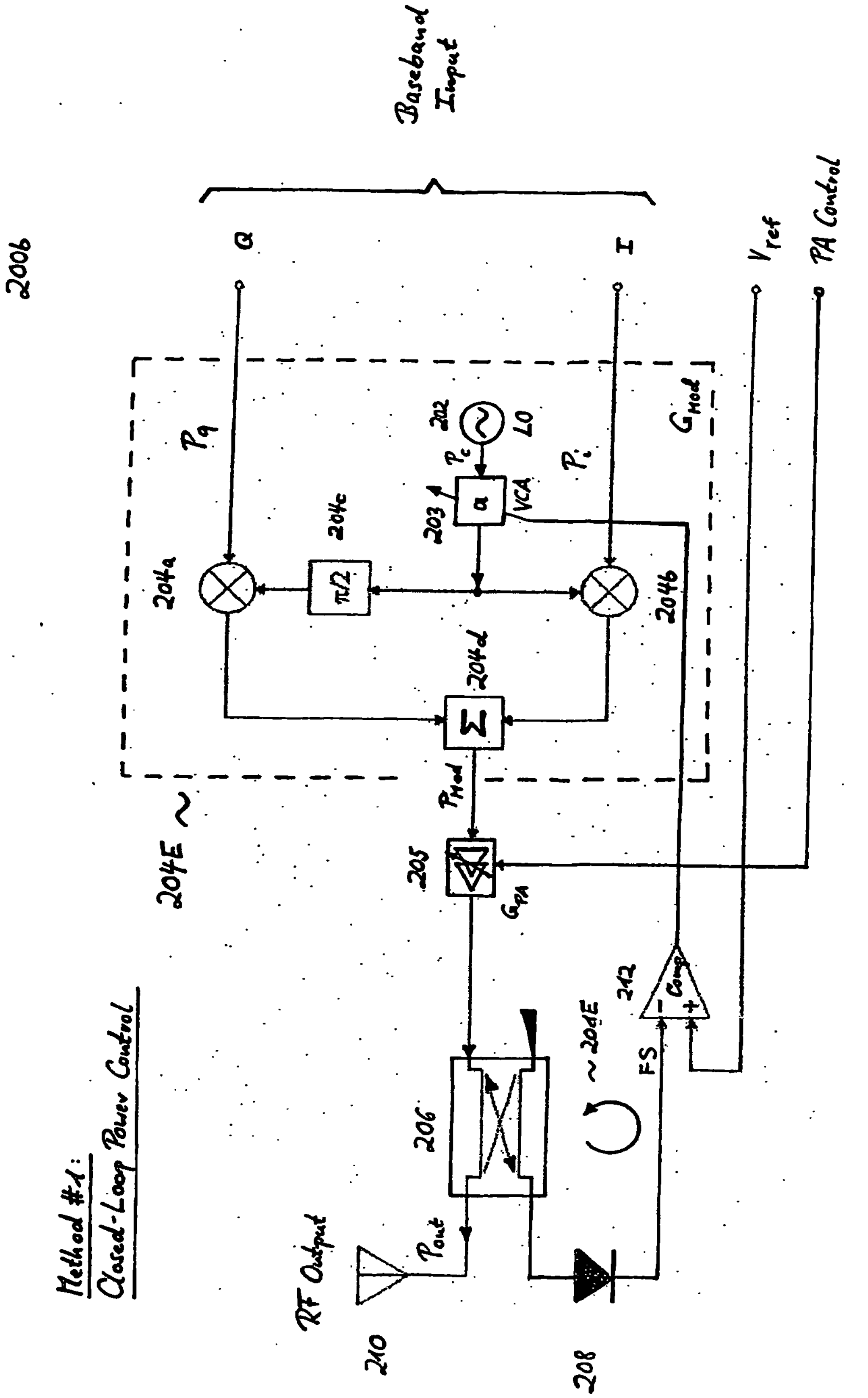
200b
Baseband Input
Q
I
Vref
PA Control
Pq
Pi
Pc
202
LO
203
a
VCA
GMod
204a
204b
204c
π/2
204d
Σ
PMod
204E
205
GPA
212
Comp
FS
206
~ 206E
208
210
Pout
RF Output
Method #1:
Closed-Loop Power Control

Fig. 2b

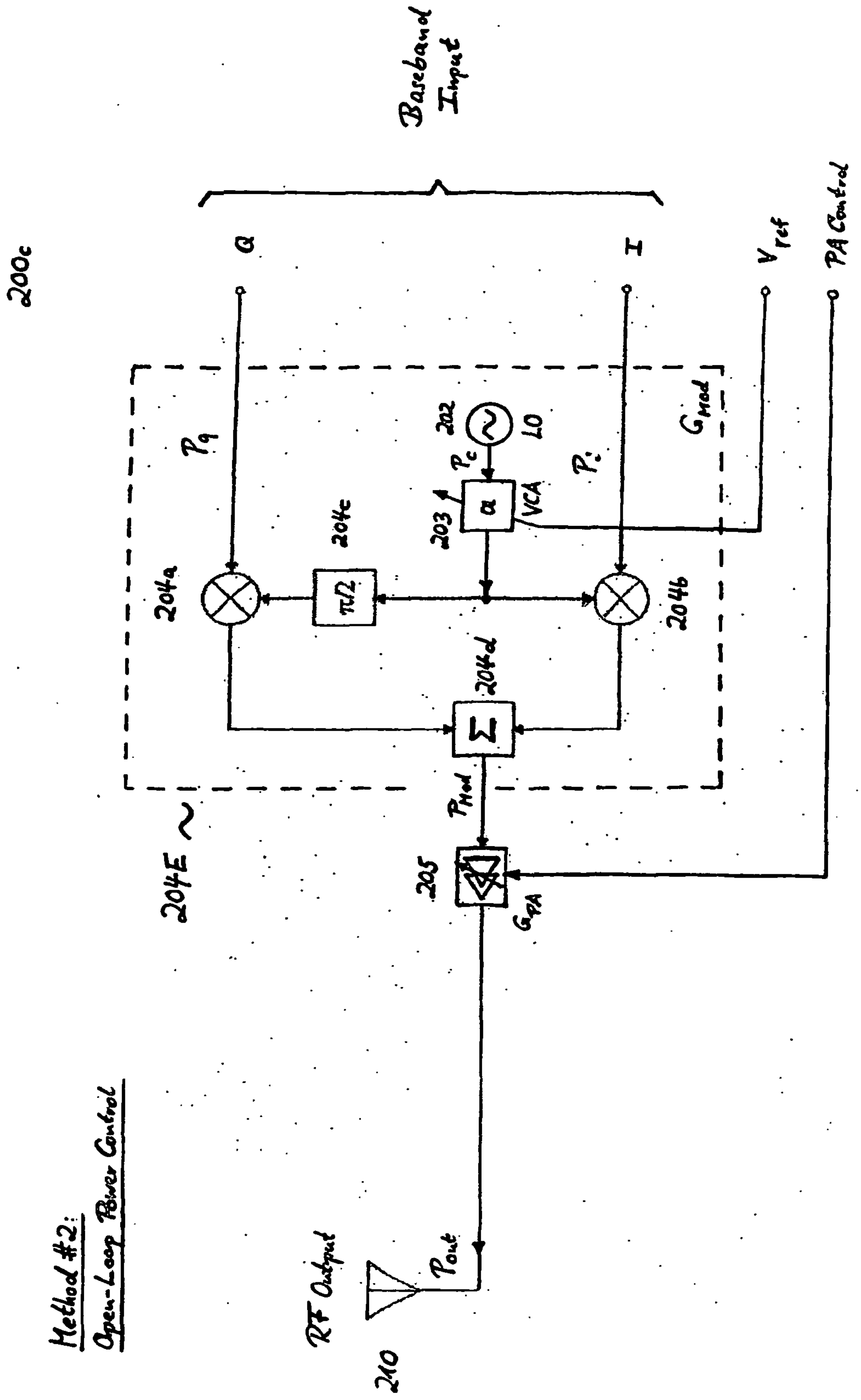
200c
Baseband Input
Q
I
$V_{ref}$
PA Control
$G_{Mod}$
$P_q$
$P_c$
$P_i$
202
LO
203
a
VCA
204c
π/2
204a
204b
204d
Σ
$P_{Mod}$
204E
205
$G_{PA}$
Method #2:
Open-Loop Power Control
RF Output
$P_{out}$
210

Fig. 2c

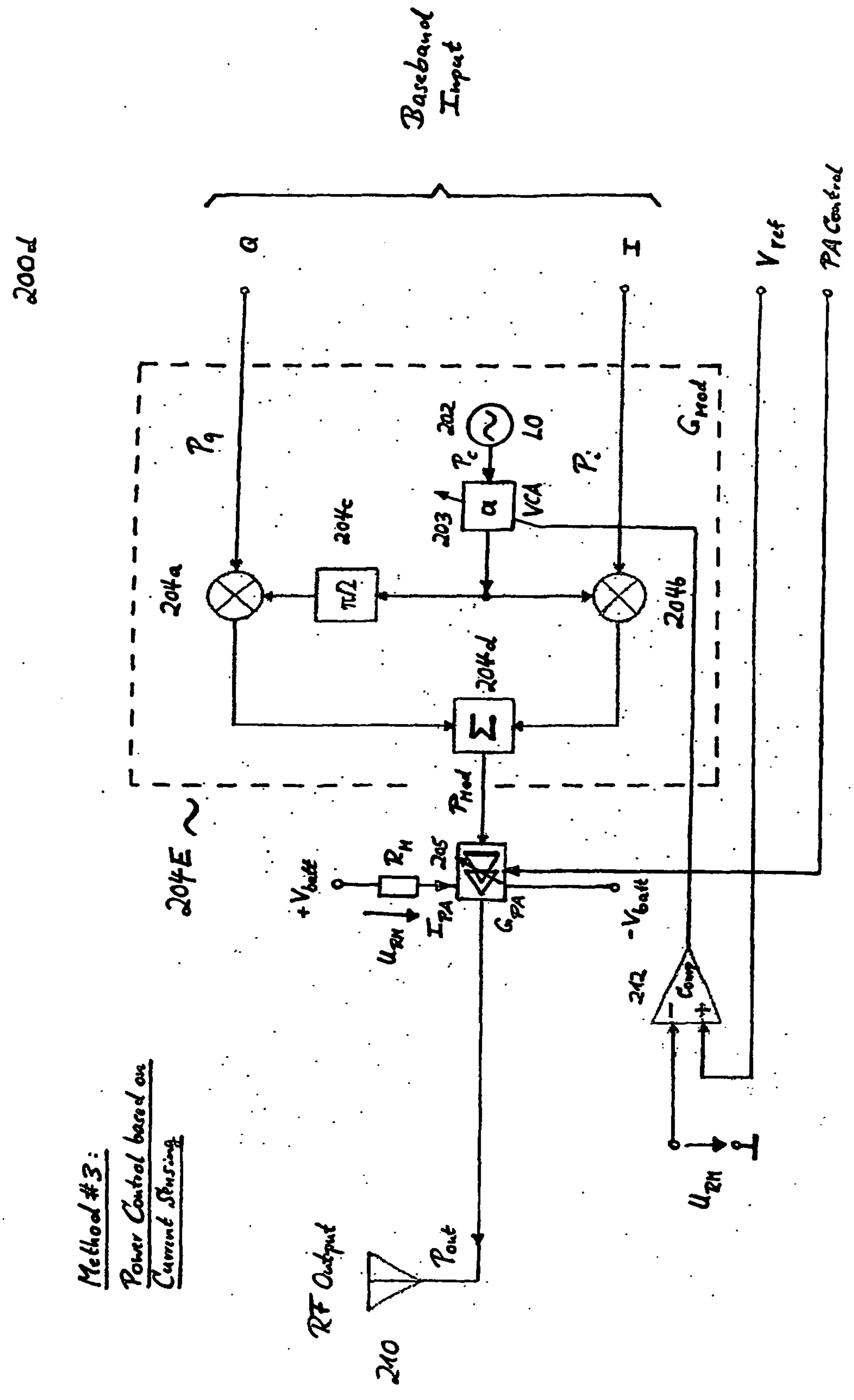
Baseband Input
Q
I
V ref
PA Control
200d
204a
204b
204c
204d
202
203
LO
VCA
G Mod
204E
R M
205
+V batt
-V batt
I PA
U RM
G PA
212
Comp
P out
RF Output
210
Method #3:
Power Control based on
Current Sensing

Fig. 2d

300a

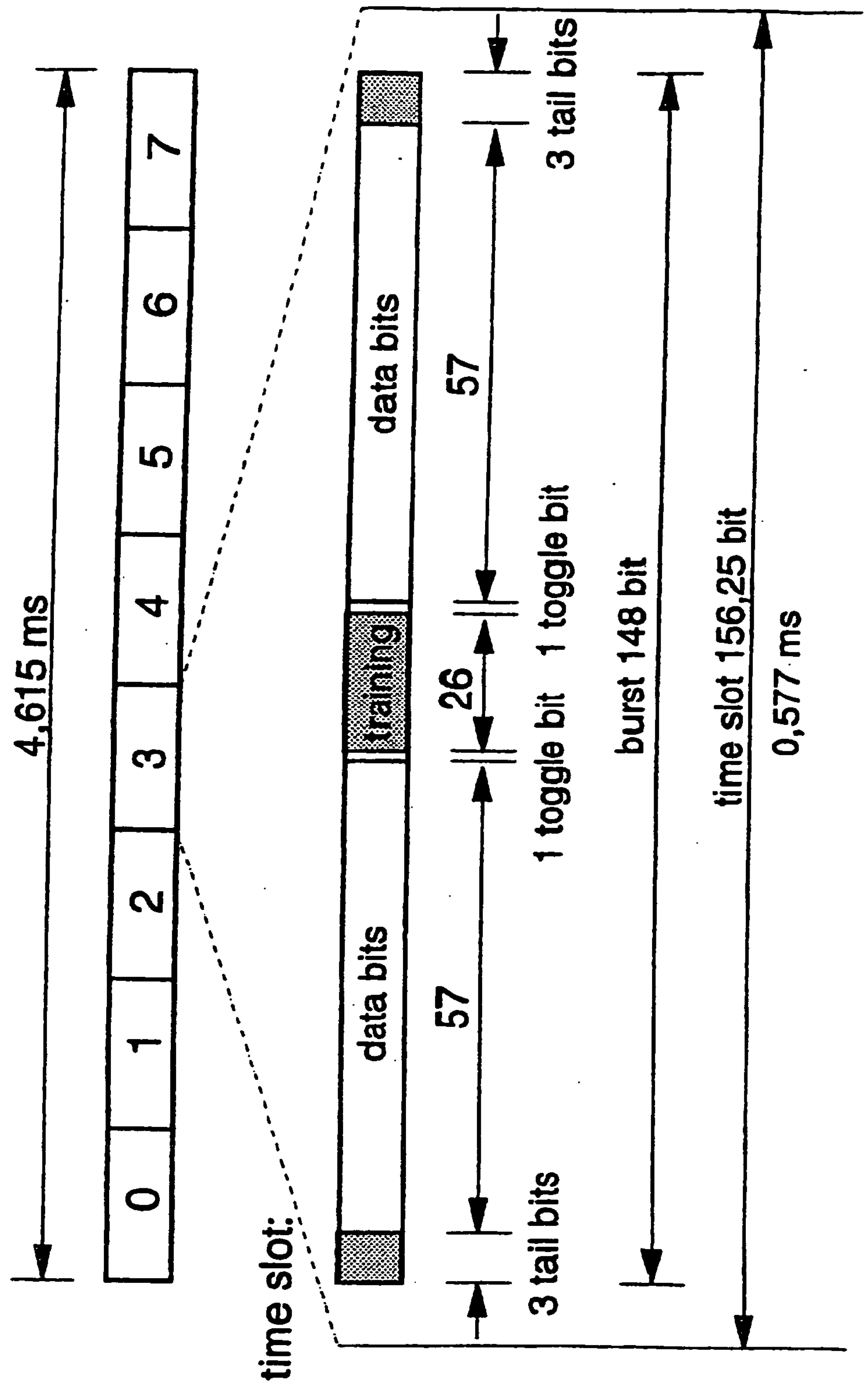
4,615 ms
0
1
2
3
4
5
6
7
time slot:
3 tail bits
57
data bits
1 toggle bit
26
training
1 toggle bit
57
data bits
3 tail bits
burst 148 bit
time slot 156,25 bit
0,577 ms

Fig. 3a

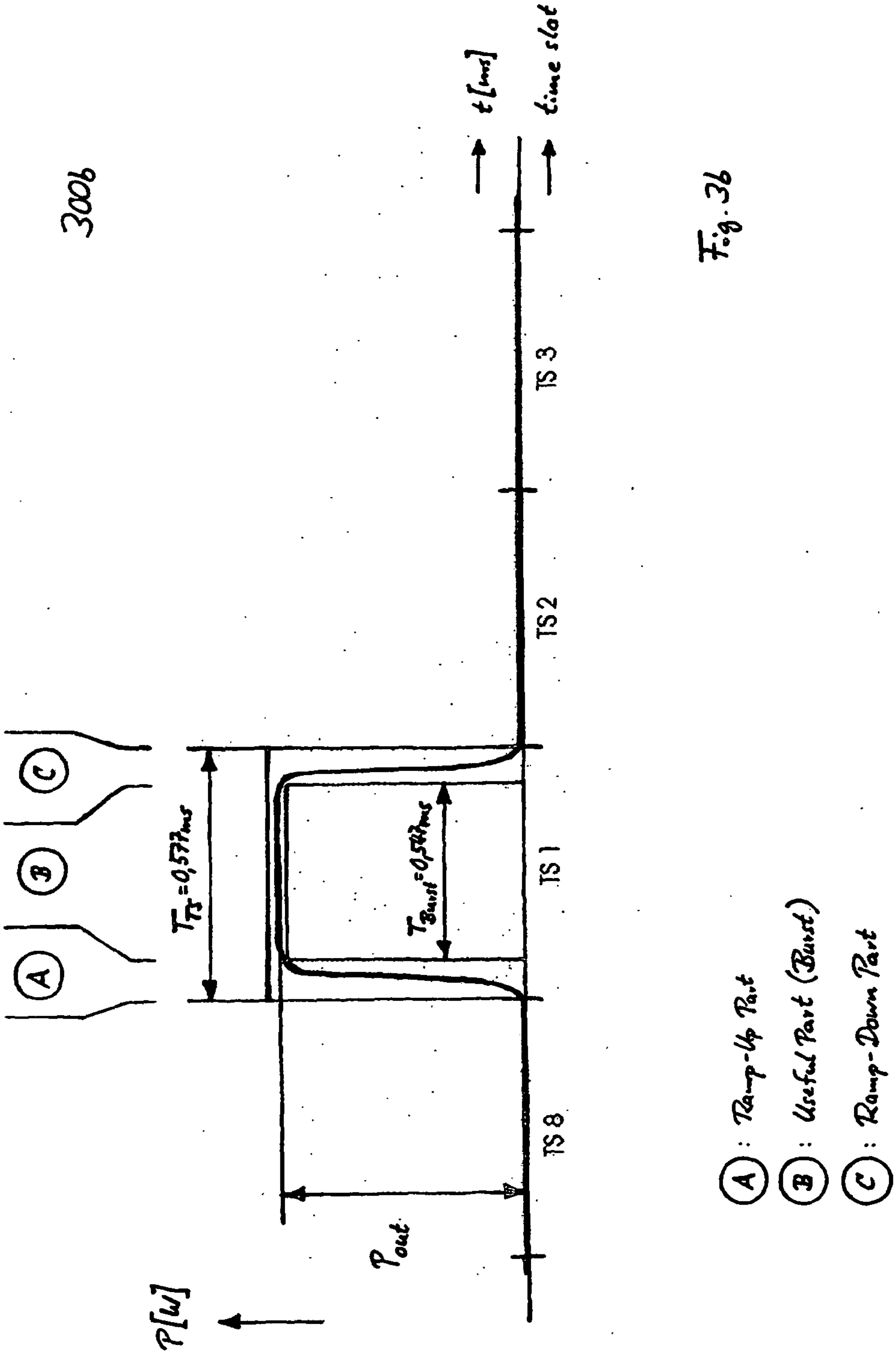
300b
t [ms]
time slot
TS 8
TS 1
TS 2
TS 3
A
B
C
T_TS=0,577ms
T_Burst=0,542ms
P_out
P [W]
A : Ramp-Up Part
B : Useful Part (Burst)
C : Ramp-Down Part

Fig. 3b

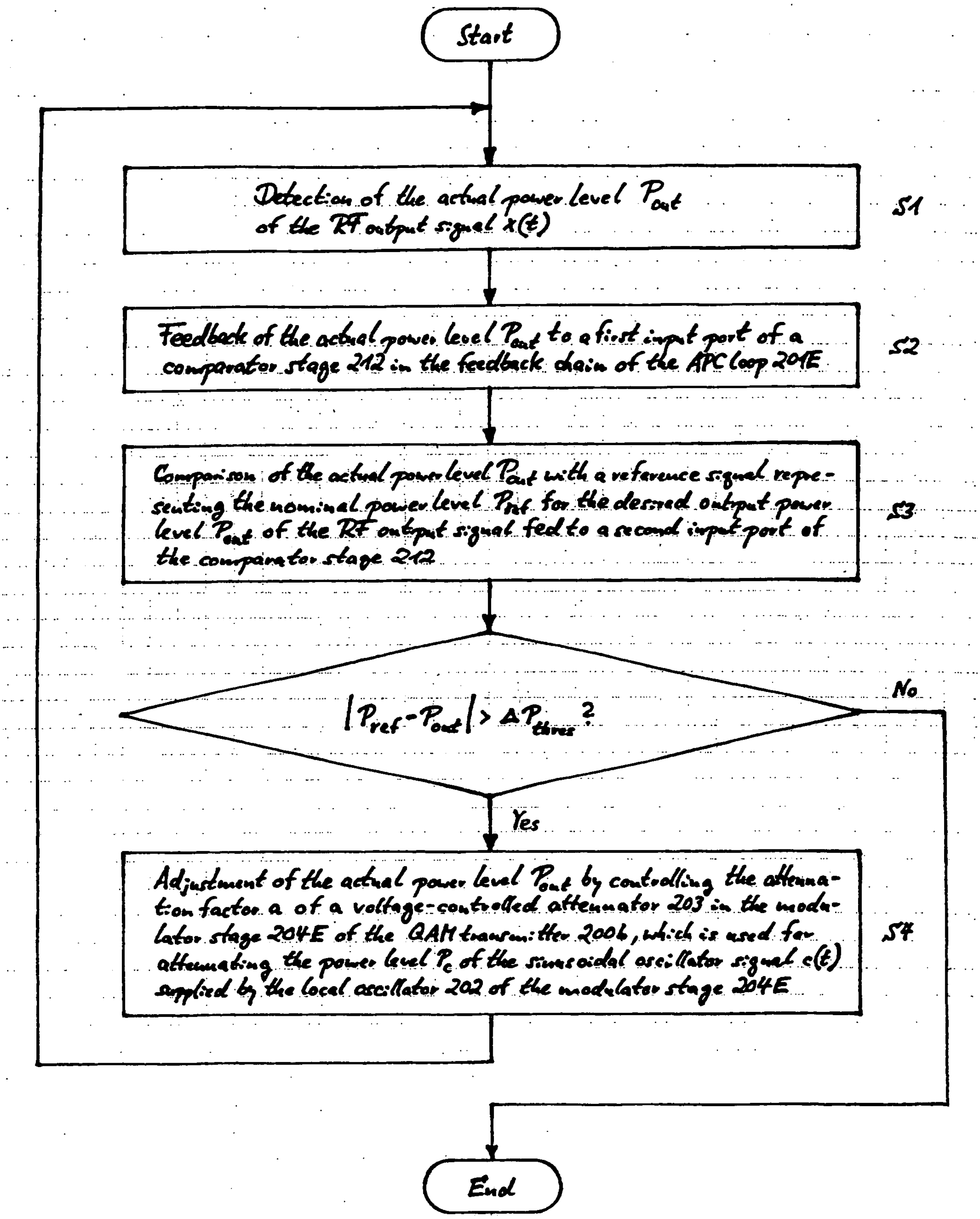
Start
Detection of the actual power level $P_{out}$ of the RF output signal $x(t)$
S1
Feedback of the actual power level $P_{out}$ to a first input port of a comparator stage 212 in the feedback chain of the APC loop 201E
S2
Comparison of the actual power level $P_{out}$ with a reference signal representing the nominal power level $P_{ref}$ for the desired output power level $P_{out}$ of the RF output signal fed to a second input port of the comparator stage 212
S3
$|P_{ref} - P_{out}| > \Delta P_{thres}$?
No
Yes
Adjustment of the actual power level $P_{out}$ by controlling the attenuation factor a of a voltage-controlled attenuator 203 in the modulator stage 204E of the QAM transmitter 200b, which is used for attenuating the power level $P_c$ of the sinusoidal oscillator signal $c(t)$ supplied by the local oscillator 202 of the modulator stage 204E
S4
End

Fig. 4